(19) Europäisches Patentamt
European Patent Office
Office européen des brevets

(11) **EP 2 579 322 A1**

(12) **EUROPEAN PATENT APPLICATION**
published in accordance with Art. 153(4) EPC

(43) Date of publication:
**10.04.2013 Bulletin 2013/15**

(51) Int Cl.:
***H01L 31/04*** *(2006.01)*

(21) Application number: **11786379.5**

(22) Date of filing: **17.02.2011**

(86) International application number:
**PCT/JP2011/053357**

(87) International publication number:
**WO 2011/148679 (01.12.2011 Gazette 2011/48)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.05.2010 JP 2010121544**

(71) Applicant: **Sharp Kabushiki Kaisha
Osaka-shi, Osaka 545-8522 (JP)**

(72) Inventors:
• **NISHIMURA, Kazuhito
Osaka 545-8522 (JP)**

• **NASUNO, Yoshiyuki
Osaka 545-8522 (JP)**
• **NAKANO, Takanori
Osaka 545-8522 (JP)**

(74) Representative: **Müller - Hoffmann & Partner
Patentanwälte
Innere Wiener Strasse 17
81667 München (DE)**

(54) **PHOTOVOLTAIC DEVICE**

(57)    A photoelectric conversion device including a substrate (1) and a pin type photoelectric conversion layer (11, 12) disposed on the surface of the substrate (1) is provided. The pin type photoelectric conversion layer (11, 12) includes a first pin type photoelectric conversion layer (11) formed by stacking a p type semiconductor layer (3), an i type semiconductor layer (4) serving as an amorphous semiconductor layer and an n type semiconductor layer (5). The first pin type photoelectric conversion layer (11) includes the first portion located on a part of the surface of the substrate (1) and the second portion located on another part of the surface of the substrate (1). The first portion is higher in concentration of at least one impurity element selected from oxygen, nitrogen and carbon than the second portion. The first portion is less in thickness than the second portion.

FIG.1

**Description**

TECHNICAL FIELD

The present invention relates to a photoelectric conversion device.

BACKGROUND ART

In recent years, from the viewpoint of global environmental problems, such as a problem of the exhaustion of energy resources and an increase in $CO_2$ in the atmosphere, clean energy has been desired to be developed. Solar photovoltaic power generation using, in particular, solar cells has been developed and put into practical use as a new energy source, and is now on the way to progress.

The currently most popular solar cell is a bulk crystal-based solar cell produced using a bulk crystal such as single crystal silicon or polycrystalline silicon for a photoelectric conversion layer converting light energy into electrical energy. The production volume of the bulk crystal-based solar cell has been increased to cause a reduction in the price of the solar cell module. Consequently, the solar photovoltaic power generation system has rapidly come into widespread use.

Furthermore, a thin film-based solar cell is currently under development as a next-generation solar cell technology, by which a photoelectric conversion layer is formed with a thin film to significantly reduce the amount of used materials, thereby allowing a further reduction in the manufacturing cost, as compared with the above-mentioned bulk crystal-based solar cell.

Examples of such a thin film-based solar cell may include a thin film silicon solar cell (an amorphous silicon solar cell, a microcrystalline silicon solar cell, an amorphous silicon/microcrystalline silicon tandem solar cell, and the like), a CIS ($CuInSe_2$) thin film solar cell, a CIGS ($Cu(In, Ga)Se_2$) thin film solar cell, a CdTe solar cell, and the like.

The above-described thin film-based solar cell is generally manufactured by stacking thin films constituting a semiconductor layer and an electrode layer on a large-area substrate made of glass, metal foil or the like, using a vacuum film forming apparatus such as a plasma CVD apparatus, a sputtering apparatus or a vapor deposition apparatus.

Therefore, according to the thin film-based solar cell, the substrate surface is increased in area and the manufacturing apparatus is consequently increased in size, thereby allowing a large-area solar cell to be achieved in a single film formation. Accordingly, the production efficiency can be improved, which also allows a reduction in the manufacturing cost.

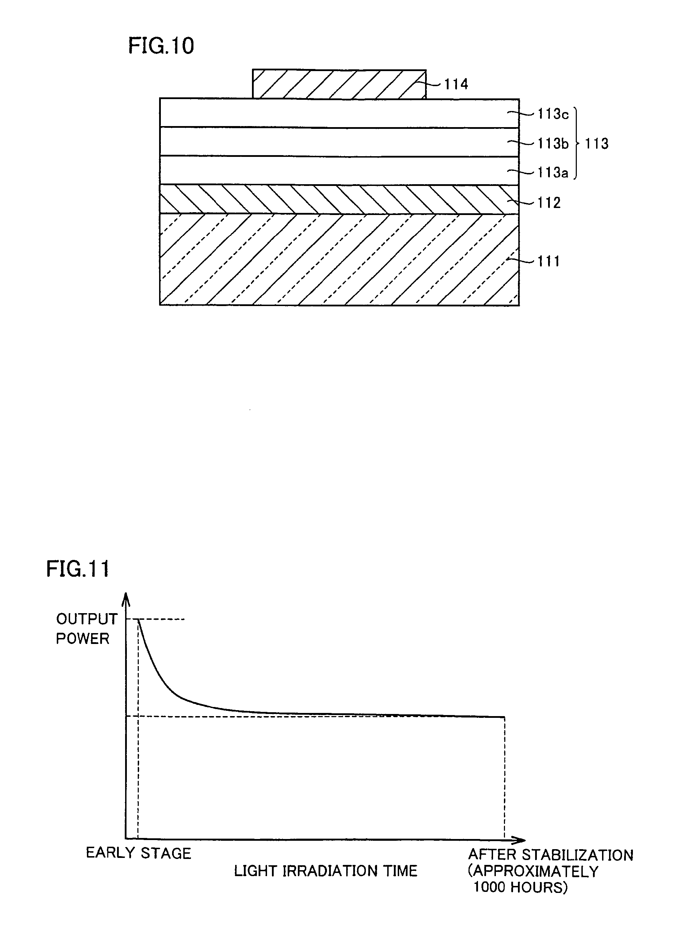

For example, PTL 1 (Japanese Patent Laying-Open No. 2000-277773) discloses an amorphous silicon solar cell that is an example of a thin film-based solar cell. Fig. 10 shows a schematic cross-sectional view of the conventional amorphous silicon solar cell disclosed in PTL 1.

The conventional amorphous silicon solar cell shown in Fig. 10 is produced by stacking a transparent electrode 112 made of tin oxide; a photovoltaic film 113 formed of a laminated body including a p layer 113a, an i layer 113b and an n layer 113c made of hydrogenated amorphous silicon; and a backside electrode 114 in this order on a glass substrate 111.

CITATION LIST

PATENT LITERATURE

PTL 1: Japanese Patent Laying-Open No. 2000-277773

SUMMARY OF INVENTION

TECHNICAL PROBLEM

However, the amorphous silicon solar cell has light degradation characteristics that the output power is decreased with the lapse of the light irradiation time corresponding to the time during which the amorphous silicon solar cell is irradiated with light, for example, as shown, in Fig. 11. In Fig. 11, the horizontal axis shows a light irradiation time while the vertical axis shows the output power of the amorphous silicon solar cell.

In this case, it is considered that the output power of the amorphous silicon solar cell obtained after the light irradiation time period has fully elapsed (after stabilization) can be maintained at a relatively high level by lowering the light degradation rate showing the degree of the light degradation characteristics (the proportion of the reduced amount of the output power from the initial output power to the output power after stabilization with respect to the initial output power).

Therefore, in the technical field of the photoelectric conversion device such as a thin film-based solar cell made using an amorphous semiconductor such as amorphous silicon, there is a particularly strong demand to develop a photoelectric conversion device capable of suppressing the light degradation rate at a relatively low level.

In light of the above-described circumstances, the present invention aims to provide a photoelectric conversion device capable of suppressing the light degradation rate at a relatively low level.

SOLUTION TO PROBLEM

The present invention provides a photoelectric conversion device including a substrate and a pin type photoelectric conversion layer disposed on a surface of the substrate. The pin type photoelectric conversion layer includes a first pin type photoelectric conversion layer formed by stacking a p type semiconductor layer, an i type semiconductor layer serving as an amorphous semiconductor layer and an n type semiconductor layer. The first pin type photoelectric conversion layer includes a first portion located on a part of the surface of the substrate and a second portion located on another part of the surface of the substrate. The first portion is higher in concentration of at least one impurity element selected from oxygen, nitrogen and carbon than the second portion. The first portion is less in thickness than the second portion.

In the photoelectric conversion device of the present invention, it is preferable that the first portion is located on a peripheral edge region on the surface of the substrate, and the second portion is located on a center region on the surface of the substrate corresponding to a region inside with respect to the peripheral edge region.

Furthermore, in the photoelectric conversion device of the present invention, assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that an average thickness of the second portion is defined as Da and an average thickness of the first portion is defined as Db, it is preferable that the following equation (I) is satisfied;

$$0.76 \, \mathrm{Da} \leq \mathrm{Db} \leq 0.91 \, \mathrm{Da} \, \ldots \, (\mathrm{I}).$$

Furthermore, in the photoelectric conversion device of the present invention, assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that an oxygen concentration in the second portion is defined as Pa(O) and an oxygen concentration in the first portion is defined as Pb(O), it is preferable that the following equation (II) is satisfied;

$$3.5 \, \mathrm{Pa(O)} \leq \mathrm{Pb(O)} \, \ldots \, (\mathrm{II}).$$

Furthermore, in the photoelectric conversion device of the present invention, assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that an oxygen concentration in the first portion is defined as Pb(O), it is preferable that the following equation (III) is satisfied;

$$\mathrm{Pb(O)} \geq 1 \times 10^{20} \ [\mathrm{atoms/cm}^3] \ ... \ \mathrm{(III)}.$$

Furthermore, in the photoelectric conversion device of the present invention, assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that a nitrogen concentration in the second portion is defined as Pa(N) and a nitrogen concentration in the first portion is defined as Pb(N), it is preferable that the following equation (IV) is satisfied;

$$5 \ \mathrm{Pa(N)} \leq \mathrm{Pb(N)} \ ... \ \mathrm{(IV)}.$$

Furthermore, in the photoelectric conversion device of the present invention, assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that a nitrogen concentration in the first portion is defined as Pb(N), it is preferable that the following equation (V) is satisfied;

$$\mathrm{Pb(N)} \geq 1 \times 10^{18} \ [\mathrm{atoms/cm}^3] \ ... \ \mathrm{(V)}.$$

Furthermore, in the photoelectric conversion device of the present invention, assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that a carbon concentration in the second portion is defined as Pa(C) and a carbon concentration in the first portion is defined as Pb(C), it is preferable that the following equation (VI) is satisfied;

$$4 \ \mathrm{Pa(C)} \leq \mathrm{Pb(C)} \ ... \ \mathrm{(VI)}.$$

Furthermore, in the photoelectric conversion device of the present invention, assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that a carbon concentration in the first portion is defined as Pb(C), it is preferable that the following equation (VII) is satisfied;

$$\mathrm{Pb(C)} \geq 2 \times 10^{18} \ [\mathrm{atoms/cm}^3] \ ... \ \mathrm{(VII)}.$$

In the photoelectric conversion device of the present invention, it is preferable that the pin type photoelectric conversion layer includes the first pin type photoelectric conversion layer and a second pin type photoelectric conversion layer in this order from the substrate side, the second pin type photoelectric conversion layer includes a p type semiconductor layer, an i type semiconductor layer and an n type semiconductor layer, and the second pin type photoelectric conversion layer is less in thickness in the first portion than in the second portion.

Furthermore, in the photoelectric conversion device of the present invention, the first portion is located on a peripheral edge region on the surface of the substrate. The second portion is located on a center region on the surface of the substrate corresponding to a region inside with respect to the peripheral edge region. Assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that an average thickness of the second pin type photoelectric conversion layer in the second portion is defined as Da2 and an average thickness of the second pin type photoelectric conversion layer in the first portion is defined as Db2, it is preferable that the following equation (VIII) is satisfied;

$$0.76\,\mathrm{Da2} \leq \mathrm{Db2} \leq 0.91\,\mathrm{Da2} \dots \text{(VIII)}.$$

Furthermore, in the photoelectric conversion device of the present invention, the first portion is located on a peripheral edge region on the surface of the substrate. The second portion is located on a center region on the surface of the substrate corresponding to a region inside with respect to the peripheral edge region. Assuming that a center point on the surface of the substrate is defined as an A point, an optional one point on an outer periphery on the surface of the substrate is defined as a B point, and points dividing a line segment AB connecting the A point and the B point internally in a ratio 0.115:0.655:0.23 are defined as a C point and a D point sequentially from the A point side, a region between a course of the B point and a course of the D point obtained when the B point is moved around once along the outer periphery on the surface of the substrate while the A point is fixed is defined as the peripheral edge region, and a region inside a course of the C point is defined as the center region; and assuming that an average thickness of the second portion is defined as Da, an average thickness of the first portion is defined as Db, an average thickness of the second pin type photoelectric conversion layer in the second portion is defined as Da2, and an average thickness of the second pin type photoelectric conversion layer in the first portion is defined as Db2, it is preferable that the following equation (IX) is satisfied;

$$\mathrm{Db2/Da2} \leq \mathrm{Db/Da} \dots \text{(IX)}.$$

Furthermore, in the photoelectric conversion device of the present invention, it is preferable that an end face of the substrate having the first portion provided thereon includes a portion to which a semiconductor component adheres and a portion to which the semiconductor component does not adhere, and an end face of the substrate having the second portion provided thereon has the semiconductor component not adhering thereto.

ADVANTAGEOUS EFFECTS OF INVENTION

The present invention can provide the photoelectric conversion device capable of suppressing the light degradation rate at a relatively low level.

BRIEF DESCRIPTION OF DRAWINGS

Fig. 1 is an enlarged schematic cross-sectional view of a super-straight type photoelectric conversion device of an embodiment.
Fig. 2 is a schematic perspective plan view of the photoelectric conversion device of the embodiment as seen from the reflective electrode side.
Fig. 3 is a schematic plan view of the surface of a substrate used for the photoelectric conversion device of the present embodiment.
Fig. 4 is a schematic plan view of another example surface of the substrate used for the photoelectric conversion device of the present embodiment.
Fig. 5 is a schematic configuration diagram of an example of the vacuum film forming apparatus used for forming the first pin type photoelectric conversion layer and the second pin type photoelectric conversion layer of the photoelectric conversion device of the present embodiment.

Figs. 6(a) to 6(c) each are a schematic perspective view illustrating an example of a method for manufacturing a photoelectric conversion device of another embodiment.

Fig. 7 is a schematic plan view of the surface of a glass substrate used in Example.

Fig. 8 is an enlarged schematic cross-sectional view of a super-straight type photoelectric conversion device of a different embodiment.

Fig. 9 is an enlarged schematic cross-sectional view of a super-straight type photoelectric conversion device of a further different embodiment.

Fig. 10 is a schematic cross-sectional view of a conventional amorphous silicon solar cell.

Fig. 11 is a diagram showing the relation between the output power and the light irradiation time of the amorphous silicon solar cell.

DESCRIPTION OF EMBODIMENTS

The embodiments of the present invention will be hereinafter described. In the accompanying drawings of the present invention, the same or corresponding components are designated by the same reference characters.

<Photoelectric Conversion Device>

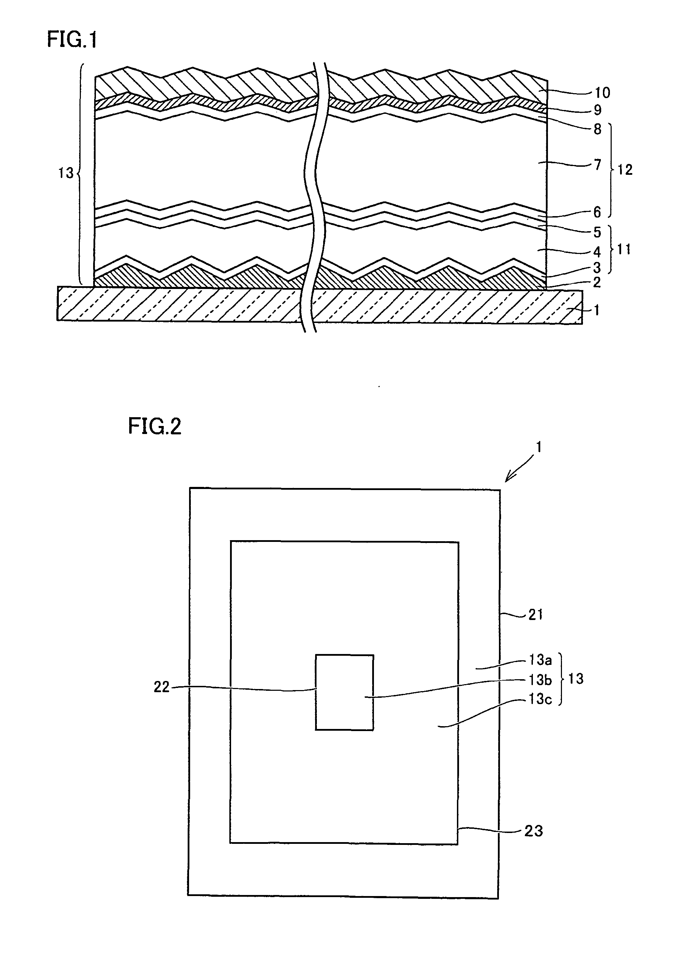

Fig. 1 shows an enlarged schematic cross-sectional view of a super-straight type photoelectric conversion device of an embodiment that is an example of the photoelectric conversion device of the present invention.

The photoelectric conversion device shown in Fig. 1 includes a substrate 1 and a cell structure body 13 disposed on the surface of substrate 1. Cell structure body 13 includes a transparent conductive film 2 disposed on the surface of substrate 1, a first pin type photoelectric conversion layer 11 disposed on the surface of transparent conductive film 2, a second pin type photoelectric conversion layer 12 disposed on the surface of first pin type photoelectric conversion layer 11, a transparent conductive film 9 disposed on the surface of second pin type photoelectric conversion layer 12, and a reflective electrode 10 disposed on the surface of transparent conductive film 9.

In this case, first pin type photoelectric conversion layer 11, which is an amorphous silicon photoelectric conversion layer, includes a first p type semiconductor layer 3 disposed on the surface of transparent conductive film 2, a first i type semiconductor layer 4 disposed on the surface of first p type semiconductor layer 3, and a first n type semiconductor layer 5 disposed on the surface of first i type semiconductor layer 4.

Furthermore, second pin type photoelectric conversion layer 12, which is a microcrystalline silicon photoelectric conversion layer, includes a second p type semiconductor layer 6 disposed on the surface of first n type semiconductor layer 5, a second i type semiconductor layer 7 disposed on the surface of second p type semiconductor layer 6, and a second n type semiconductor layer 8 disposed on the surface of second i type semiconductor layer 7.

Although the super-straight type photoelectric conversion device causing light to be applied from the substrate 1 side will be described in the present embodiment, a sub-straight type photoelectric conversion device causing light to be applied from the side opposite to the substrate 1 side may be employed.

<Substrate 1>

Substrate 1 to be used may be, for example, a glass substrate, a resin substrate including a transparent resin such as a polyimide resin, or a translucent substrate allowing light to pass therethrough, such as a substrate formed by stacking these substrates.

In addition, when a sub-straight type photoelectric conversion device is used as a photoelectric conversion device, substrate 1 may be, for example, a non-translucent substrate such as a stainless substrate that does not allow light to pass therethrough.

<Transparent Conductive Film 2>

Examples of transparent conductive film 2 may be a tin oxide layer, an ITO (Indium Tin Oxide) film, a zinc oxide film, or a single layer formed of a film obtained by adding a small quantity of impurities to these films, or a multiple layer obtained by stacking these films several times. It is desirable that transparent conductive film 2 allows a large quantity of light to pass therethrough and also has excellent conductivity. When transparent conductive film 2 is formed of a multiple layer, all of the layers forming thereof may be made of the same material, or at least one layer may be made of a material different from those of other layers.

Furthermore, it is preferable that transparent conductive film 2 has a surface on which concavities and convexities are formed, for example, as shown in Fig. 1. Due to concavities and convexities formed on the surface of transparent conductive film 2, the incident light from the substrate 1 side can be scattered and/or refracted to extend the light path length, which allows improvement in the light confinement effect in first pin type photoelectric conversion layer 11, so that the short-circuit current density can be increased. Examples of a method for forming concavities and convexities on the surface of transparent conductive film 2 may include a method using a machining process like an etching method or sandblasting, a method utilizing crystal growth in transparent conductive film 2, or the like.

<First Pin Type Photoelectric Conversion Layer 11>

First pin type photoelectric conversion layer 11 is an amorphous silicon photoelectric conversion layer formed of a laminated body including first p type semiconductor layer 3, first i type semiconductor layer 4 and first n type semiconductor layer 5.

First p type semiconductor layer 3 to be used may be, for example, a single layer formed of a p type layer such as a p type amorphous silicon layer, a p type microcrystalline silicon layer, a p type amorphous silicon carbide layer, or a p type amorphous silicon nitride layer, or a multiple layer obtained by stacking these layers several times. When first p type semiconductor layer 3 is formed of a multiple layer, all of the layers forming thereof may be made of the same semiconductor material, or at least one layer may be made of a semiconductor material different from those of other layers. First p type semiconductor layer 3 may be doped with a p type impurity element, for example, boron and the like.

First i type semiconductor layer 4 may be, for example, a single layer or a multiple layer formed of an amorphous silicon layer. Although first i type semiconductor layer 4 is an intrinsic semiconductor onto which neither a p type impurity element nor an n type impurity element is doped, a small amount of p type impurity element and n type impurity element may be contained in first i type semiconductor layer 4 in the vicinity of the interface with first p type semiconductor layer 3 and the interface with first n type semiconductor layer 5, respectively. Furthermore, in order to control the band gap in first i type semiconductor layer 4, it is also possible to use amorphous silicon carbide, amorphous silicon germanium and the like to which elements such as carbon and germanium are positively added.

First n type semiconductor layer 5 may be, for example, a single layer formed of an n type layer such as an n type amorphous silicon layer or an n type microcrystalline silicon layer, or a multiple layer formed by stacking these layers several times. When first n type semiconductor layer 5 is formed of a multiple layer, all of the layers forming thereof may be made of the same semiconductor material, or at least one layer may be made of a semiconductor material different from those of other layers. First n type semiconductor layer 5 may be doped with an n type impurity element, for example, phosphorus and the like.

In addition, first p type semiconductor layer 3 and first n type semiconductor layer 5 may be made of the same semiconductor material as that of first i type semiconductor layer 4, or may be made of different semiconductor materials. For example, a p type amorphous silicon layer and an i type amorphous silicon layer may be used for first p type semiconductor layer 3 and first i type semiconductor layer 4, respectively, while an n type microcrystalline silicon layer may be used for first n type semiconductor layer 5. For example, a p type amorphous silicon carbide layer may be used for first p type semiconductor layer 3, an amorphous silicon layer may be used for first i type semiconductor layer 4, and an n type microcrystalline silicon layer may be used for first n type semiconductor layer 5.

Furthermore, in the present specification, "amorphous silicon" represents a concept including "hydrogenated amorphous silicon" while "microcrystalline silicon" represents a concept including "hydrogenated microcrystalline silicon".

<Second Pin Type Photoelectric Conversion Layer 12>

Second pin type photoelectric conversion layer 12 is a microcrystalline silicon photoelectric conversion layer formed of a laminated body including second p type semiconductor layer 6, second i type semiconductor layer 7 and second n type semiconductor layer 8.

Second p type semiconductor layer 6 may be, for example, a single layer formed of a p type layer such as a p type microcrystalline silicon layer, a p type microcrystalline silicon carbide layer or a p type microcrystalline silicon nitride layer, or a multiple layer formed by stacking these layers several times. When second p type semiconductor layer 6 is formed of a multiple layer, all of the layers forming thereof may be made of the same semiconductor material, or at least one layer may be made of a semiconductor material different from those of other layers. Second p type semiconductor layer 6 may be doped with a p type impurity element, for example, boron and the like.

Second i type semiconductor layer 7 may be, for example, a single layer or a multiple layer formed of a microcrystalline silicon layer. Although second i type semiconductor layer 7 is an intrinsic semiconductor layer onto which neither a p type impurity element nor an n type impurity element is doped, a small amount of p type impurity element and n type impurity element are contained in second i type semiconductor layer 7 in the vicinity of the interface with second p type semiconductor layer 6 and the interface with second n type semiconductor layer 8, respectively.

Second n type semiconductor layer 8 may be, for example, a single layer formed of an n type layer such as an n type amorphous silicon layer or an n type microcrystalline silicon layer, or a multiple layer formed by stacking these layers several times. When second n type semiconductor layer 8 is formed of a multiple layer, all of the layers forming thereof may be made of the same semiconductor material, or at least one layer may be made of a semiconductor material different from those of other layers. Second n type semiconductor layer 8 may be doped with an n type impurity element, for example, phosphorus and the like.

In addition, second p type semiconductor layer 6 and second n type semiconductor layer 8 may be made of the same semiconductor material as that of second i type semiconductor layer 7, or may be made of different semiconductor materials. Furthermore, second p type semiconductor layer 6 and second n type semiconductor layer 8 may also be made of the same semiconductor material, or may be made of different semiconductor materials.

<Transparent Conductive Film 9>

Transparent conductive film 9 can be made of a film that allows light to pass therethrough and also has conductivity, such as a single layer formed of, for example, a tin oxide film, an ITO film, a zinc oxide film, or a film obtained by adding a small amount of impurities to these films, or a multiple layer formed by stacking these layers several times. When transparent conductive film 9 is formed of a multiple layer, all of the layers forming thereof may be made of the same material, or at least one layer may be made of a material different from those of other layers.

Transparent conductive film 9 does not need to be formed. However, transparent conductive film 9 can achieve the light confinement improving effect and the light reflectance improving effect for the incident light. In addition to this, due to existence of transparent conductive film 9, diffusion of atoms forming reflective electrode 10 into second pin type photoelectric conversion layer 12 can be suppressed. Therefore, it is preferable to form transparent conductive film 9.

<Reflective Electrode 10>

Reflective electrode 10 is often made of a material having a high light reflectance, and for example, may be made of a conductive layer such as an Ag (silver) layer, an Al (aluminum) layer or a laminated body formed of these layers.

Since reflective electrode 10 can reflect the light that is not absorbed in first pin type photoelectric conversion layer 11 and second pin type photoelectric conversion layer 12 and direct this light back to first pin type photoelectric conversion layer 11 and second pin type photoelectric conversion layer 12, it contributes to improvement in the photoelectric conversion efficiency.

When a sub-straight type photoelectric conversion device is used as the photoelectric conversion device, it is preferable that reflective electrode 10 is, for example, configured to have a shape such as a comb shape so as not to cover the entire surface of the photoelectric conversion device, from the viewpoint of allowing light to be incident thereon.

<Photoelectric Conversion Layer>

In the photoelectric conversion device of the present embodiment, first pin type photoelectric conversion layer 11 is configured such that the first portion having a relatively high impurity concentration (the concentration of at least one impurity element selected from oxygen, nitrogen and carbon; the same applies in the following) is less in thickness than the second portion having a relatively low impurity concentration.

The photoelectric conversion device of the present embodiment has a tandem junction structure formed of first pin type photoelectric conversion layer 11 serving as an amorphous silicon photoelectric conversion layer and second pin type photoelectric conversion layer 12 serving as a microcrystalline silicon photoelectric conversion layer. In this case, a wide range of wavelengths of light can be absorbed to generate electric power, so that a photoelectric conversion device having high photoelectric conversion efficiency can be implemented. Therefore, the photoelectric conversion device of the present embodiment is, for example, suitable for application to a thin film silicon solar cell used for a solar photovoltaic power generation system for which the power generation cost (the cost required for generating unit electric power) is of highly importance.

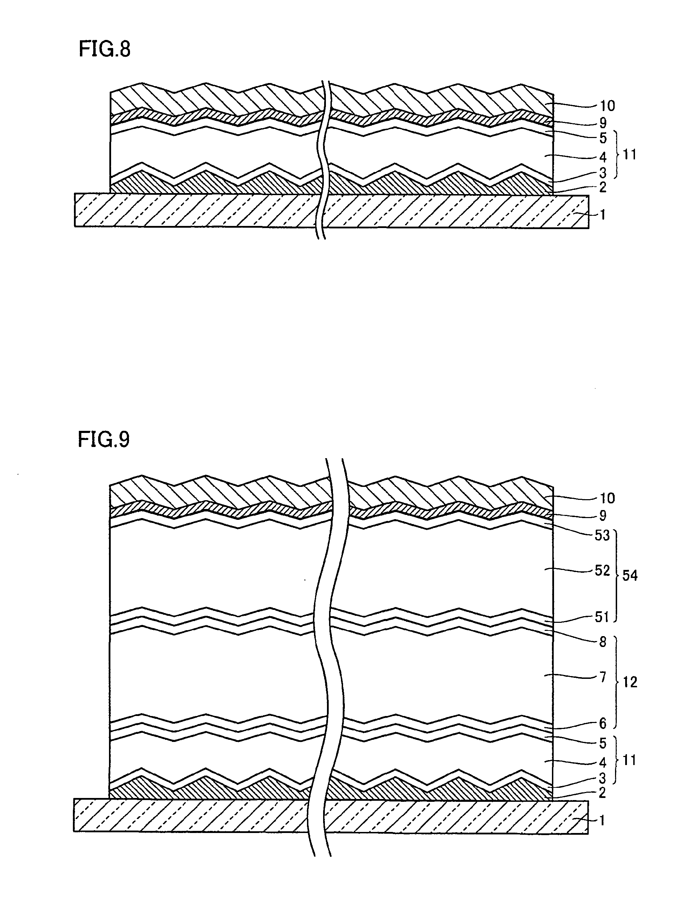

Furthermore, an embodiment different from those as described above may include a photoelectric conversion device having a single junction structure not including second pin type photoelectric conversion layer 12 but including only first pin type photoelectric conversion layer 11 which is an amorphous silicon photoelectric conversion layer as a photoelectric conversion layer, as illustrated in the schematic cross-sectional view in Fig. 8.

Furthermore, an embodiment different from those as described above may include a photoelectric conversion device having a triple junction structure including, as a photoelectric conversion layer, first pin type photoelectric conversion layer 11 serving as an amorphous silicon photoelectric conversion layer, second pin type photoelectric conversion layer 12 serving as a microcrystalline silicon photoelectric conversion layer, and a third pin type photoelectric conversion layer 54 serving as a microcrystalline silicon photoelectric conversion layer, as illustrated in the schematic cross-sectional view in Fig. 9. This is preferable since a wider range of wavelengths of light can be absorbed, thereby allowing implementation of a photoelectric conversion device having photoelectric conversion efficiency higher than that in the case of the tandem junction structure. In the photoelectric conversion device having a triple junction structure shown in Fig. 9, second pin type photoelectric conversion layer 12 may be a microcrystalline silicon photoelectric conversion layer, an amorphous silicon photoelectric conversion layer, an amorphous silicon germanium photoelectric conversion layer, or the like. Third pin type photoelectric conversion layer 54 may be a microcrystalline silicon photoelectric conversion layer, a microcrystalline silicon germanium photoelectric conversion layer or the like. Furthermore, third pin type photoelectric conversion layer 54 is formed of a laminated body including a third p type semiconductor layer 51, a third i type semiconductor layer 52 and a third n type semiconductor layer 53.

Thus, in the technical field of the thin film silicon solar cell for which the power generation cost is of highly importance, reduction of the manufacturing cost is an important issue. Therefore, while cost reduction of the manufacturing apparatus is inevitable, the manufacturing apparatus also needs to be increased in size from the viewpoint of improving the production efficiency (increasing the manufacturing yield of the solar cell that can be produced in the same facilities) to reduce the manufacturing cost.

In order to achieve both of cost reduction and size increase of the manufacturing apparatus, it is considered effective to use a vacuum film forming apparatus having a relatively low degree of vacuum, that is, a vacuum film forming apparatus having a relatively large leak rate, to thereby allow formation of first pin type photoelectric conversion layer 11 and second pin type photoelectric conversion layer 12. For reducing the leak rate in a large-size vacuum film forming apparatus, a vacuum seal member, vacuum pumping capability and the like are required to achieve a high performance, as compared with a small-size vacuum film forming apparatus. This leads to an increase in the cost of the film forming apparatus, with the result that the manufacturing cost of the photoelectric conversion device is increased. On the other hand, in the case of the vacuum film forming apparatus having a large leak rate, the device configuration of the vacuum seal member, the vacuum pump and the like can be simplified, thereby allowing reduction in the cost of the film forming apparatus. Therefore, if a photoelectric conversion layer can be formed by a vacuum film forming apparatus having a large leak rate, the manufacturing cost for the photoelectric conversion device can be reduced as compared with the case where a photoelectric conversion layer is formed by a high-vacuum film forming apparatus having a low leak rate.

The following characteristics (i) and (ii) are included in first pin type photoelectric conversion layer 11 and second pin type photoelectric conversion layer 12, respectively, that are formed on the surface of a large-area substrate 1 using a large-size vacuum film forming apparatus having a large leak rate for the purpose of reducing the manufacturing cost.

(i) The concentration of impurities remaining in the vacuum film forming apparatus is higher than that in the case of the high-vacuum film forming apparatus having a low leak rate. Accordingly, the concentration of the impurities taken into each of first pin type photoelectric conversion layer 11 and second pin type photoelectric conversion layer 12 is also increased.

(ii) The vacuum film forming apparatus is large in size while the concentration of the impurities taken into each of first pin type photoelectric conversion layer 11 and second pin type photoelectric conversion layer 12 differs between the substrate peripheral edge region and the substrate center region in the in-plane direction on the surface of substrate 1 (the direction parallel to the surface of substrate 1). Accordingly, the impurity concentration varies in the in-plane direction on the surface of substrate 1.

Furthermore, as described above, since the amorphous silicon solar cell has light degradation characteristics that the output power is decreased with the lapse of the light irradiation time, first pin type photoelectric conversion layer 11 serving as an amorphous silicon photoelectric conversion layer also has light degradation characteristics. Furthermore, several experimental results indicate that there is a correlation between the light degradation rate showing the degree of light degradation of first pin type photoelectric conversion layer 11 serving as an amorphous silicon photoelectric conversion layer and the impurity concentration distribution in first pin type photoelectric conversion layer 11 serving as an amorphous silicon photoelectric conversion layer. More specifically, it has been found that, in first pin type photoelectric conversion layer 11, the first portion having a relatively high impurity concentration is higher in light degradation rate than the second portion having a relatively low impurity concentration.

Furthermore, the thicker the first i type semiconductor layer 4 of first pin type photoelectric conversion layer 11 is, the higher the light degradation rate is, while the thinner the first i type semiconductor layer 4 of first pin type photoelectric conversion layer 11 is, the lower the light degradation rate is.

Accordingly, in the photoelectric conversion device of the present embodiment, first pin type photoelectric conversion layer 11 is configured such that the first portion having a relatively high impurity concentration is less in thickness than the second portion having a relatively low impurity concentration.

Consequently, it becomes possible to lower the light degradation rate in the first portion having a relatively high impurity concentration in first pin type photoelectric conversion layer 11. Accordingly, the output power obtained after stabilization of the entire photoelectric conversion device (after the light irradiation time has fully elapsed) can be increased, so that the light degradation rate of the photoelectric conversion device can be suppressed at a relatively low level.

Fig. 2 shows a schematic perspective plan view of the photoelectric conversion device of the embodiment shown in Fig. 1, as seen from the reflective electrode 10 side.

A cell structure body 13 provided on the surface of substrate 1 includes a first cell structure body 13a located on at least a part of the peripheral edge region corresponding to a peripheral region including an outer periphery on the surface of substrate 1 (the region between a solid line 21 and a solid line 23 in Fig. 2); a second cell structure body 13b located on the region inside the peripheral edge region on the surface of substrate 1 and on at least a part of the center region including the center on the surface of substrate 1 (the region surrounded by a solid line 22 in Fig. 2); and a third cell structure body 13c located on at least a part of the intermediate region between the peripheral edge region and the center region on the surface of substrate 1.

Particularly, when cell structure body 13 is formed on the surface of large-area substrate 1 using a large-size vacuum film forming apparatus having a large leak rate, it is highly likely that the first portion having a relatively high impurity concentration serves as first pin type photoelectric conversion layer 11 in first cell structure body 13a that is located on the peripheral edge region on the surface of substrate 1 while the second portion having a relatively low impurity concentration serves as first pin type photoelectric conversion layer 11 in second cell structure body 13b that is located on the center region on the surface of substrate 1.

Therefore, in the photoelectric conversion device of the present embodiment, it is preferable that first pin type photoelectric conversion layer 11 in first cell structure body 13a located on the peripheral edge region on the surface of substrate 1 is less in thickness than first pin type photoelectric conversion layer 11 in second cell structure body 13b located on the center region on the surface of substrate 1. In this case, first i type semiconductor layer 4 located on the peripheral edge region on the surface of substrate 1 is less in thickness than first i type semiconductor layer 4 located on the center region on the surface of substrate 1. Therefore, it is more likely that the light degradation rate of the photoelectric conversion device can be suppressed low.

Furthermore, from the viewpoint of lowering the light degradation rate of the photoelectric conversion device of the present embodiment, it is preferable to satisfy the relation of the following equations (I) to (IX) obtained, for example, when the peripheral edge region and the center region on the surface of substrate 1 are defined as described below.

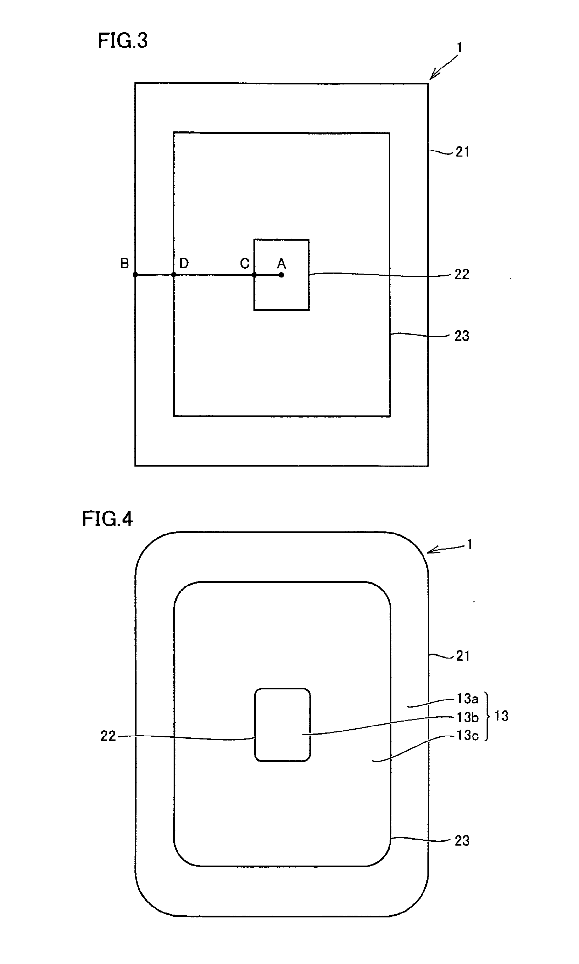

Fig. 3 shows a schematic plan view of the surface of substrate 1 used for the photoelectric conversion device of the present embodiment. In this case, assume that the center point on the surface of substrate 1 is defined as an A point, an optional one point on the outer periphery on the surface of substrate 1 is defined as a B point, the line segment connecting the A point and the B point is defined as a line segment AB, and different two points on line segment AB are defined as a C point and a D point, respectively. Also, defined as a peripheral edge region is a region between the course of the B point (a solid line 21 in Fig. 3) and the course of the D point (a solid line 23 in Fig. 3) obtained when the B point is moved around once along the outer periphery on the surface of substrate 1 in the state where the A point is fixed while the ratio among a length AC of the line segment connecting the A point and the C point, a length CD of the line segment connecting the C point and the D point and a length DB of the line segment connecting the D point and the B point is maintained in the relation of AC:CD:DB = 0.115:0.655:0.23. Also assume that the region surrounded by the course of the C point (solid line 22 in Fig. 3) is defined as a center region. Specifically, the points dividing line segment AB obtained by connecting the A point and the B point internally in the ratio 0.115:0.655:0.23 are defined as a C point and a D point sequentially from the A point side.

Then, assuming that the average thickness of first pin type photoelectric conversion layer 11 located on the center region on the surface of substrate 1 is defined as Da and the average thickness of first pin type photoelectric conversion layer 11 located on the peripheral edge region on the surface of substrate 1 is defined as Db, it is preferable to satisfy the following equation (I). In this case, it is more likely that the light degradation rate of the photoelectric conversion device of the present embodiment can be suppressed at a further lower level.

$$0.76 \, \mathrm{Da} \leq \mathrm{Db} \leq 0.91 \, \mathrm{Da} \, \dots \, (I)$$

Furthermore, assuming that the oxygen concentration in first pin type photoelectric conversion layer 11 located on the center region on the surface of substrate 1 is defined as Pa(O) and the oxygen concentration in first pin type photoelectric conversion layer 11 located on the peripheral edge region on the surface of substrate 1 is defined as Pb(O), it is preferable to satisfy the foregoing equation (I) and the following equation (II). In this case, it is possible to more remarkably achieve the effect of lowering the light degradation rate of the photoelectric conversion device in the case of the film thickness distribution as defined in the foregoing equation (I). Furthermore, it is preferable to satisfy the foregoing equation (I) and the following equation (III), and more preferable to satisfy all of the foregoing equations (I), (II) and (III). In other words, even in the case where the oxygen concentration in first pin type photoelectric conversion layer 11 located on the peripheral edge region of substrate 1 is very high, the effect of lowering the light degradation rate of the photoelectric conversion device can be achieved further remarkably.

$$3.5 \, Pa(O) \leq Pb(O) \ldots (II)$$

$$Pb(O) \geq 1 \times 10^{20} \, [atoms/cm^3] \ldots (III)$$

Furthermore, assuming that the nitrogen concentration in first pin type photoelectric conversion layer 11 located on the center region on the surface of substrate 1 is defined as Pa(N) and the nitrogen concentration in first pin type photoelectric conversion layer 11 located on the peripheral edge region on the surface of substrate 1 is defined as Pb(N), it is preferable to satisfy the foregoing equation (I) and the following equation (IV). In this case, it becomes possible to more remarkably achieve the effect of lowering the light degradation rate of the photoelectric conversion device in the case of the film thickness distribution as defined in the foregoing equation (I). Furthermore, it is preferable to satisfy the foregoing equation (I) and the following equation (V), and more preferable to satisfy the foregoing equations (I), (IV) and (V). In other words, even in the case where the nitrogen concentration in first pin type photoelectric conversion layer 11 located on the peripheral edge region of substrate 1 is very high, the effect of lowering the light degradation rate of the photoelectric conversion device can be achieved further remarkably.

$$5 \, Pa(N) \leq Pb(N) \ldots (IV)$$

$$Pb(N) \geq 1 \times 10^{18} \, [atoms/cm^3] \ldots (V)$$

Furthermore, assuming that the carbon concentration in first pin type photoelectric conversion layer 11 located on the center region on the surface of substrate 1 is defined as Pa(C) and the carbon concentration in first pin type photoelectric conversion layer 11 located on the peripheral edge region on the surface of substrate 1 is defined as Pb (C), it is preferable to satisfy the foregoing equation (I) and the following equation (VI). In this case, it becomes possible to more remarkably achieve the effect of lowering the light degradation rate of the photoelectric conversion device in the case of the film thickness distribution as defined in the foregoing equation (I). Furthermore, it is preferable to satisfy the foregoing equation (I) and the following equation (VII), and more preferable to satisfy the foregoing equations (I), (VI) and (VII). In other words, even in the case where the carbon concentration in first pin type photoelectric conversion layer 11 located on the peripheral edge region of substrate 1 is very high, the effect of lowering the light degradation rate of the photoelectric conversion device can be achieved further remarkably.

$$4 \, Pa(C) \leq Pb(C) \ldots (VI)$$

$$Pb(C) \geq 2 \times 10^{18} \, [atoms/cm^3] \ldots (VII)$$

Furthermore, from the viewpoint of lowering the light degradation rate of the photoelectric conversion device of the present embodiment, it is preferable to satisfy, in addition to the equation (I), the relation of at least one group of equations selected from three groups consisting of {the equation (II) and/or the equation (III)}, {the equation (IV) and/or the equation (V)} and {the equation (VI) and/or the equation (VII)}, and further more preferable to satisfy the relation of each of the foregoing equations (I) to (VII).

Furthermore, the light degradation rate of the laminate-type photoelectric conversion device is influenced by the ratio of the short-circuit current values between first pin type photoelectric conversion layer 11 serving as an amorphous silicon photoelectric conversion layer and second pin type photoelectric conversion layer 12 serving as a microcrystalline silicon photoelectric conversion layer. More specifically, light degradation occurs only in first pin type photoelectric conversion layer 11 serving as an amorphous silicon photoelectric conversion layer. Therefore, in order to decrease the degree of light degradation of first pin type photoelectric conversion layer 11 contributing to the light degradation of the entire photoelectric conversion device, it is effective to set the short-circuit current value of second pin type photoelectric conversion layer 12 to be lower than the short-circuit current value of first pin type photoelectric conversion layer 11. Since the short-circuit current value of each pin type photoelectric conversion layer is positively correlated with the film thickness of each layer, second pin type photoelectric conversion layer 12 is configured to have a film thickness so as to set the short-circuit current value of second pin type photoelectric conversion layer 12 to be smaller than the short-circuit current value of first pin type photoelectric conversion layer 11 throughout substrate 1, thereby allowing the light degradation rate to be suppressed at a relatively low level.

Therefore, in the photoelectric conversion device of the present embodiment, it is preferable that second pin type photoelectric conversion layer 12 is less in thickness in the first portion than in the second portion.

Furthermore, from the viewpoint of lowering the light degradation rate of the photoelectric conversion device of the present embodiment, it is preferable to satisfy the relation of the following equations (VIII) and (IX) obtained, for example, when the peripheral edge region and the center region on the surface of substrate 1 are defined as in Fig. 3 described above.

Assuming that the average thickness of second pin type photoelectric conversion layer 12 in the second portion is defined as Da2 and the average thickness of second pin type photoelectric conversion layer 12 in the first portion is defined as Db2, it is preferable to satisfy the following equation (VIII). In this case, it is more likely that the light degradation rate of the photoelectric conversion device of the present embodiment can be suppressed at a further lower level.

$$0.76 \, \text{Da2} \leq \text{Db2} \leq 0.91 \, \text{Da2} \, ... \, \text{(VIII)}$$

Furthermore, assuming that the average thickness of the second portion in first pin type photoelectric conversion layer 11 is defined as Da, the average thickness of the first portion in first pin type photoelectric conversion layer 11 is defined as Db, the average thickness of second pin type photoelectric conversion layer 12 in the second portion is defined as Da2, and the average thickness of second pin type photoelectric conversion layer 12 in the first portion is defined as Db2, it is preferable to satisfy the following equation (IX). In this case, it is more likely that the light degradation rate of the photoelectric conversion device of the present embodiment can be suppressed at a further lower level. Further in this case, it is more likely that the amount of the current flowing through the photoelectric conversion device can be rate-limited to the amount of the current in second pin type photoelectric conversion layer 12.

$$\text{Db2/Da2} \leq \text{Db/Da} \, ... \, \text{(IX)}$$

It is preferable to satisfy one of the foregoing equations (VIII) and (IX), and more preferable to satisfy both of the equations.

Furthermore, the shape of the surface of substrate 1 used in the present embodiment is not limited to that shown in Fig. 3, but may be those having a surface shaped such that each of four corners on the surface of substrate is rounded, for example, as shown in Fig. 4. In this case, all of four corners in each of the peripheral edge region, the intermediate region and the center region on the surface of substrate 1 are to be rounded.

Furthermore, in the drawings of the present invention, while solid line 21 corresponds to the line showing the outer periphery of the surface of substrate 1, solid lines 22 and 23 are imaginary lines, and therefore, are not necessarily provided on the surface of substrate 1.

<Manufacturing Method>

The photoelectric conversion device of the present embodiment can be manufactured, for example, as described below. First, transparent conductive film 2 is formed on the surface of substrate 1. In this case, transparent conductive film 2 is formed, for example, by methods such as the sputtering method, the CVD method, the electron beam evaporation method, the sol-gel method, the spray method, and the electrocrystallization method.

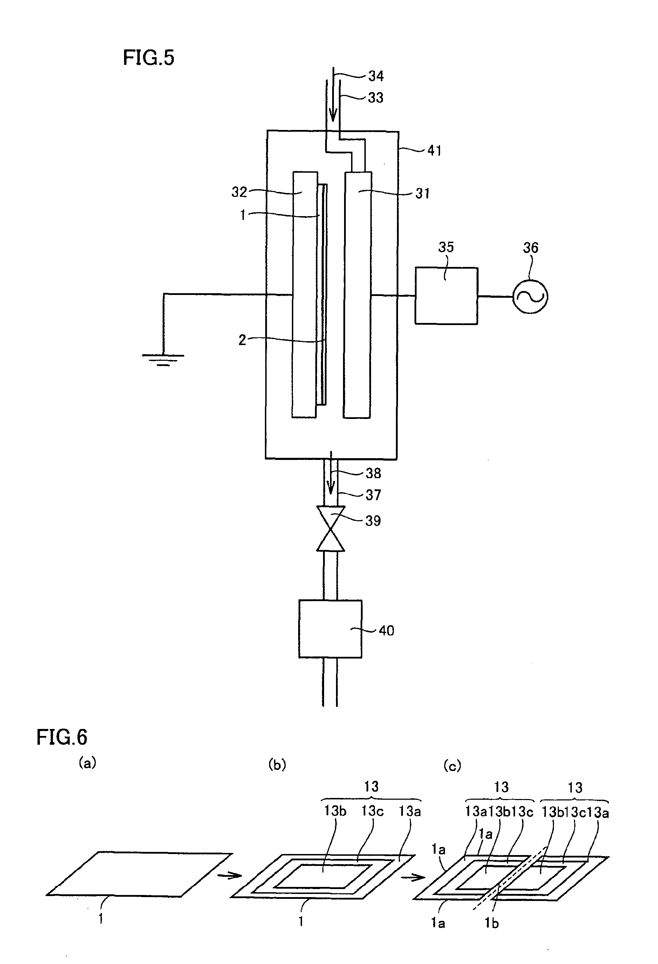

Then, for example, a large-size vacuum film forming apparatus (plasma CVD apparatus) having a large leak rate shown in the schematic configuration diagram in Fig. 5 is used to form first pin type photoelectric conversion layer 11 and second pin type photoelectric conversion layer 12 in this order by the plasma CVD method on the surface of transparent conductive film 2 formed on the surface of substrate 1.

The vacuum film forming apparatus shown in Fig. 5 includes a film forming chamber 41, a cathode 31 disposed within film forming chamber 41, an anode 32 disposed within film forming chamber 41 so as to face cathode 31, a gas introduction pipe 33 for introducing gas into cathode 31, a gas discharge pipe 37 for discharging gas to the outside of film forming chamber 41, a gate valve 39 for adjusting the amount of the gas discharged through gas discharge pipe 37, and a pump 40 for sucking the gas discharged to the outside of film forming chamber 41. In this case, cathode 31 is connected to a high-frequency power supply 36 through an impedance matching circuit 35 while anode 32 is connected to the ground.

In addition, in the vacuum film forming apparatus shown in Fig. 5, after evacuating the gas within film forming chamber 41 to set the pressure within film forming chamber 41, for example, at a pressure within the range of $10^{-4}$ to 1 Pa, film forming chamber 41 is hermetically sealed by closing gate valve 39 and the like, in which case the pressure increasing rate (leak rate) at the time when the gas enters film forming chamber 41 from the outside thereof with time to raise the pressure within film forming chamber 41 is, for example, approximately $3 \times 10^{-3}$ Pa•L/s.

Then, when forming first pin type photoelectric conversion layer 11 and second pin type photoelectric conversion layer 12, substrate 1 provided with transparent conductive film 2 is first disposed on the surface of anode 32 of vacuum film forming apparatus shown in Fig. 5. In this case, substrate 1 is disposed on the surface of anode 32 such that the surface of transparent conductive film 2 faces the surface of cathode 31.

Then, gate valve 39 is opened to cause suction by means of pump 40, thereby discharging the gas within film forming chamber 41 to the outside of film forming chamber 41 through gas discharge pipe 37 in the direction shown by an arrow 38, to set the pressure within film forming chamber 41, for example, at the pressure within the range of $10^{-4}$ to 1 Pa.

Then, for example, at least one type of gas selected from the group consisting of $SiH_4$, $H_2$, $B_2H_6$, $PH_3$, and $CH_4$ is introduced in the direction shown by an arrow 34 into cathode 31 through gas introduction pipe 33, and then, introduced between cathode 31 and anode 32 through a hole (not shown) provided in cathode 31 on the anode 32 side.

Then, an alternating-current (AC) voltage is applied between cathode 31 and anode 32 by high-frequency power supply 36, to generate plasma of the gas introduced as described above, thereby forming first p type semiconductor layer 3 on the surface of transparent conductive film 2 disposed on substrate 1.

Then, after introduction of the gas into film forming chamber 41 is stopped, the gas within film forming chamber 41 is discharged in the direction shown by arrow 38 to the outside of film forming chamber 41 through gas discharge pipe 37, to set the pressure within film forming chamber 41, for example, at the pressure within the range of $10^{-4}$ to 1 Pa.

By repeating the above-described process, first p type semiconductor layer 3, first i type semiconductor layer 4, first n type semiconductor layer 5, second p type semiconductor layer 6, second i type semiconductor layer 7, and second n type semiconductor layer 8 are formed in this order on the surface of transparent conductive film 2 provided on substrate 1, thereby forming first pin type photoelectric conversion layer 11 and second pin type photoelectric conversion layer 12.

In addition, although first p type semiconductor layer 3, first i type semiconductor layer 4 and first n type semiconductor layer 5 of first pin type photoelectric conversion layer 11 may be formed in separate film forming chambers, it is preferable to form first p type semiconductor layer 3, first i type semiconductor layer 4 and first n type semiconductor layer 5 in one film forming chamber from the viewpoint of cost reduction for the film forming apparatus.

Furthermore, although second p type semiconductor layer 6, second i type semiconductor layer 7 and second n type semiconductor layer 8 of second pin type photoelectric conversion layer 12 may also be formed in separate film forming chambers, it is preferable to form second p type semiconductor layer 6, second i type semiconductor layer 7 and second n type semiconductor layer 8 in one film forming chamber from the viewpoint of cost reduction for the film forming apparatus.

First pin type photoelectric conversion layer 11 and second pin type photoelectric conversion layer 12 can also be formed in one film forming chamber. In the present embodiment, however, first pin type photoelectric conversion layer 11 is formed using one film forming chamber while second pin type photoelectric conversion layer 12 is formed using another one film forming chamber.

Furthermore, the pressure within film forming chamber 41 at the time of forming each of the above-described first p type semiconductor layer 3, first i type semiconductor layer 4, first n type semiconductor layer 5, second p type semiconductor layer 6, second i type semiconductor layer 7, and second n type semiconductor layer 8 is set at, for example, the pressure within the range of $5 \times 10^2$ to $1.7 \times 10^3$ Pa.

Furthermore, for example, by adjusting the pressure within film forming chamber 41 and/or the distance between cathode 31 and anode 32, it is possible to adjust the magnitude of the thickness of the surface of substrate 1 in the in-plane direction in each of first p type semiconductor layer 3, first i type semiconductor layer 4, first n type semiconductor layer 5, second p type semiconductor layer 6, second i type semiconductor layer 7, and second n type semiconductor layer 8.

Also by adjusting the diameter of the hole and/or the number of the holes in the surface of cathode 31, it is possible to adjust the magnitude of the thickness of the surface of substrate 1 in the in-plane direction in each of first p type semiconductor layer 3, first i type semiconductor layer 4, first n type semiconductor layer 5, second p type semiconductor layer 6, second i type semiconductor layer 7, and second n type semiconductor layer 8.

Therefore, for example, by adjusting at least one of conditions selected from the group consisting of the pressure within film forming chamber 41, the distance between cathode 31 and anode 32, the diameter of the hole in the surface of cathode 31, and the number of the holes in the surface of cathode 31, first pin type photoelectric conversion layer 11 can be configured such that the first portion having a relatively high impurity concentration (for example, the portion on the peripheral edge region on the surface of substrate 1) is less in thickness than the second portion having a relatively low impurity concentration (for example, the portion on the center region on the surface of substrate 1).

Furthermore, the amorphous silicon layer and the microcrystalline silicon layer can be selectively produced, for example, by forming each layer such that the flow ratio of $H_2$ to $SiH_4$ ($H_2/SiH_4$ flow ratio: ($H_2$ flow rate)/($SiH_4$ flow rate)) satisfies the following equation (X).

$$(H_2/SiH_4 \text{ during formation of amorphous silicon layer flow ratio}) < (H_2/SiH_4 \text{ during}$$

$$\text{formation of microcrystalline silicon layer flow ratio}) \dots (X)$$

In the vacuum film forming apparatus shown in Fig. 5, it is preferable that the gas discharge system including gas discharge pipe 37, gate valve 39 and pump 40 has a discharging performance enough to allow the pressure within film forming chamber 41 to be set at a pressure of approximately 0.1 Pa. In this case, the vacuum film forming apparatus can be reduced in cost and improved in throughput, as compared with the vacuum film forming apparatus using a gas discharge system having a discharging performance with high vacuum and being capable of setting the pressure within film forming chamber 41 at a pressure lower than 0.1 Pa.

Furthermore, in the vacuum film forming apparatus shown in Fig. 5, high-frequency power supply 36 may be those outputting one of the AC output having a continuous wave (CW) and the pulse-modulated (on-off controlled) AC output. Furthermore, the frequency of the AC power output from high-frequency power supply 36 is generally 13.56 MHz, but is not limited thereto, and may be a frequency of, for example, several kHz to a VHF band, several kHz to a UHF band and several kHz to a microwave band.

Then, transparent conductive film 9 is formed on the surface of second n type semiconductor layer 8 of second pin type photoelectric conversion layer 12 formed as described above. In this case, transparent conductive film 9 can be formed, for example, by methods such as the sputtering method, the CVD method, the electron beam evaporation method, the sol-gel method, the spray method, and the electrocrystallization method.

Then, reflective electrode 10 is formed on the surface of transparent conductive film 9 formed as described above. In this case, reflective electrode 10 can be formed, for example, by methods such as the CVD method, the sputtering method, the vacuum evaporation method, the electron beam evaporation method, the spray method, the screen printing method, and the electrocrystallization method. In the manner as described above, the photoelectric conversion device of the present embodiment can be manufactured.

<Other Embodiments>

In addition to the manufacturing method as described above, for example, when substrate 1 is cut after forming cell structure body 13 on the surface of substrate 1, it becomes possible to manufacture a photoelectric conversion device (which will be hereinafter referred to as a "photoelectric conversion device of another embodiment") having first pin type photoelectric conversion layer 11 configured such that the first portion having a relatively high impurity concentration is less in thickness than the second portion having a relatively low impurity concentration.

For example, substrate 1 is first prepared as shown in the schematic perspective view in Fig. 6(a). Then, as shown in the schematic perspective view in Fig. 6(b), cell structure body 13, a transparent conductive film (not shown) and a reflective electrode (not shown) are formed on the surface of substrate 1 in the same manner as described above. Then, as shown in the schematic perspective view in Fig. 6(c), substrate 1 having the reflective electrode formed thereon is cut along the dashed line and divided into two pieces (which will be hereinafter referred to as the "first manufacturing method"). Consequently, it becomes possible to manufacture a photoelectric conversion device of another embodiment in which first pin type photoelectric conversion layer 11 is configured such that the first portion having a relatively high impurity concentration (for example, first pin type photoelectric conversion layer 11 in first cell structure body 13a) is less in thickness than the second portion having a relatively low impurity concentration (for example, first pin type photoelectric conversion layer 11 in second cell structure body 13b).

Furthermore, after transparent conductive film 2, first pin type photoelectric conversion layer 11 and second pin type photoelectric conversion layer 12 are formed on the surface of substrate 1, this substrate 1 is cut and divided into two pieces. Then, transparent conductive film 9 and reflective electrode 10 are formed on the surface of each of second pin type photoelectric conversion layers 12 on divided substrates 1 (which will be hereinafter referred to as the "second manufacturing method"). Also in this case, the photoelectric conversion device of another embodiment can be manufactured.

The photoelectric conversion device of another embodiment manufactured as described above has a cut surface 1b exposed by cutting substrate 1 and a peripheral edge surface 1a of substrate 1 already exposed before substrate 1 is cut.

Then, also in the photoelectric conversion device of another embodiment, first pin type photoelectric conversion layer 11 is configured such that the first portion having a relatively high impurity concentration is less in thickness than the second portion having a relatively low impurity concentration.

Accordingly, also in the photoelectric conversion device of another embodiment, first pin type photoelectric conversion layer 11 serving as an amorphous silicon photoelectric conversion layer can be configured such that first i type semiconductor layer 4 is less in thickness in the first portion than in the second portion. Therefore, it is possible to lower the light degradation rate in the first portion having a relatively high impurity concentration, and also possible to increase the output power obtained after stabilization of the entire photoelectric conversion device (after the light irradiation time period has fully elapsed). Consequently, the light degradation rate of the entire photoelectric conversion device can be suppressed at a relatively low level.

In the above description, although cell structure body 13 is not necessarily formed in such a shape as shown in Figs. 6(b) and 6(c), it is intentionally illustrated as in Figs. 6(b) and 6(c) in order to clearly define the boundaries of first cell structure body 13a, second cell structure body 13b and third cell structure body 13c.

Although the photoelectric conversion device of another embodiment is produced by dividing substrate 1 into two pieces in the above description, the number of cut pieces of substrate 1 is not limited to two, but substrate 1 may be cut into, for example, four or six pieces.

Furthermore, it can be determined in the following manner whether or not the photoelectric conversion device of another embodiment is employed.

Specifically, in the case where a photoelectric conversion device is manufactured by the first manufacturing method, the semiconductor components serving as constituents of first pin type photoelectric conversion layer 11 and second pin type photoelectric conversion layer 12, and the constituents of transparent conductive film 9 and reflective electrode 10 may adhere to peripheral edge surface 1a of substrate 1. On the other hand, the semiconductor components serving as constituents of first pin type photoelectric conversion layer 11 and second pin type photoelectric conversion layer 12, and the constituents of transparent conductive film 9 and reflective electrode 10 do not adhere to cut surface 1b of substrate 1. Accordingly, when substrate 1 has a side surface to which the semiconductor components serving as constituents of first pin type photoelectric conversion layer 11 and second pin type photoelectric conversion layer 12 and the constituents of transparent conductive film 9 and reflective electrode 10 do not adhere, it can be considered that the photoelectric conversion device of another embodiment manufactured by the first manufacturing method is employed.

Furthermore, in the case where the photoelectric conversion device is manufactured by the second manufacturing method, the semiconductor components serving as constituents of first pin type photoelectric conversion layer 11 and second pin type photoelectric conversion layer 12 may adhere to peripheral edge surface 1a of substrate 1, but the semiconductor components serving as constituents of first pin type photoelectric conversion layer 11 and second pin type photoelectric conversion layer 12 do not adhere to cut surface 1b of substrate 1. Accordingly, in the case where substrate 1 has a side surface to which the semiconductor components serving as constituents of first pin type photoelectric conversion layer 11 and second pin type photoelectric conversion layer 12 do not adhere, it can be considered that the photoelectric conversion device of another embodiment manufactured by the second manufacturing method is employed.

Specifically, in the case where the photoelectric conversion device is manufactured by the first manufacturing method or the second manufacturing method, for example as shown in Fig. 6(c), the side surface of substrate 1 having the first portion of first pin type photoelectric conversion layer 11 provided thereon includes a portion to which the semiconductor component adheres (peripheral edge surface 1a) and a portion to which the semiconductor component does not adhere (the portion of cut surface 1b on which first cell structure body 13a is provided). The side surface of substrate 1 having the second portion of first pin type photoelectric conversion layer 11 provided thereon (the portion of cut surface 1b on which second cell structure body 13b is provided) has no portion to which the semiconductor component adheres.

Accordingly, it can be confirmed whether or not the photoelectric conversion device of another embodiment is employed, by studying the distribution of the adhering semiconductor components serving as constituents of first pin type photoelectric conversion layer 11 and second pin type photoelectric conversion layer 12 on the side surface of substrate 1 of the photoelectric conversion device.

Examples

<Amorphous Silicon Photoelectric Conversion Layer of Sample Numbers 1 to 17>

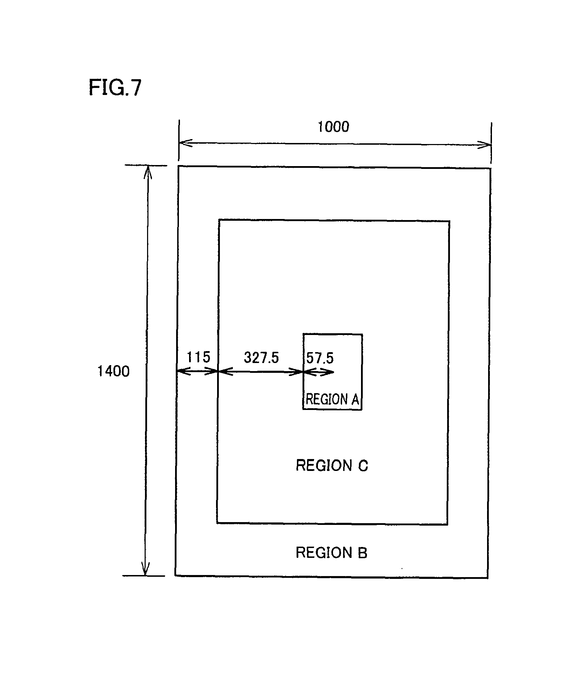

First, prepared was a substrate on which a tin oxide layer was formed in advance by the CVD method on the surface of the glass substrate made of nonalkali glass and provided with a surface having a long side length of 1400 mm $\times$ a short side length of 1000 mm $\times$ a thickness of 3.9 mm, as shown in the schematic plan view in Fig. 7.

Then, the substrate having the above-described tin oxide layer provided thereon was disposed within the film forming chamber of the plasma CVD apparatus serving as a vacuum film forming apparatus in which an ultimate vacuum was 0.1 Pa while the leak rate was $3 \times 10^{-3}$ Pa•L/s. Then, after evacuating the gas within the film forming chamber until the pressure within the film forming chamber of the plasma CVD apparatus reached 0.1 Pa, $H_2$ gas, $SiH_4$ gas, $B_2H_6$ gas, and $CH_4$ gas were introduced into the film forming chamber, thereby forming a p type amorphous silicon carbide layer on the surface of the tin oxide layer by the plasma CVD method.

Then, after stopping introduction of the gas into the film forming chamber and evacuating the gas within the film forming chamber until the pressure within the film forming chamber reached 0.1 Pa, $H_2$ gas and $SiH_4$ gas were introduced into the film forming chamber, thereby forming a non-doped i type amorphous silicon layer on the surface of the p type amorphous silicon carbide layer by the plasma CVD method.

Then, after stopping introduction of the gas into the film forming chamber and evacuating the gas within the film forming chamber until the pressure within the film forming chamber reached 0.1 Pa, $H_2$ gas, $SiH_4$ gas and $PH_3$ gas were introduced into the film forming chamber, thereby forming an n type amorphous silicon layer on the non-doped i type amorphous silicon layer by the plasma CVD method. Then, the flow rate of the $H_2$ gas and the flow rate of the $SiH_4$ gas were changed so as to raise the $H_2/SiH_4$ flow ratio (($H_2$ flow rate)/($SiH_4$ flow rate)), thereby forming an n type microcrystalline silicon layer on the surface of the n type amorphous silicon layer similarly by the plasma CVD method.

As described above, amorphous silicon photoelectric conversion layers of sample numbers 1 to 17 each formed of a laminated body including a p type amorphous silicon carbide layer, a non-doped i type amorphous silicon layer, an n type amorphous silicon layer, and an n type microcrystalline silicon layer were formed on the surface of the above-described substrate. In this case, the amorphous silicon photoelectric conversion layers of sample numbers 1 to 17 were formed with different conditions for forming the amorphous silicon photoelectric conversion layer.

In addition, as to the amorphous silicon photoelectric conversion layers of sample numbers 1 to 17, in order that the amorphous silicon photoelectric conversion layer formed on a region B on the surface of the glass substrate shown in Fig. 7 (the region outside a region C on the surface of the glass substrate shown in Fig. 7) was less in thickness than the amorphous silicon photoelectric conversion layer formed on a region A, the distance between the cathode and the anode of the plasma CVD apparatus was set at 13 to 15 mm and the pulse modulated RF power was used as excitation electric power at the time when forming the amorphous silicon photoelectric conversion layer.

Assuming that the center point on the surface of the glass substrate shown in Fig. 7 is defined as an A point and one point on the outer periphery on the surface of the glass substrate is defined as a B point, to define a line segment AB connecting the A point and the B point, and also assuming that the intersection of line segment AB and the outer periphery of region A is defined as a C point and the intersection of line segment AB and the outer periphery of region C is defined as a D point, the ratio of a length AC of line segment AC, a length CD of line segment CD and a length DB of line segment DB is defined as AC:CD:DB = 0.115:0.655:0.23.

Specifically, as shown in Fig. 7, the boundary between region A and region C in the short-side direction on the surface of the glass substrate is located at the position separated by a distance of 57.5 mm from the center point on the surface of the glass substrate.

Furthermore, as shown in Fig. 7, the boundary between region C and region B in the short side direction on the surface of the glass substrate is located at the position separated by a distance of 327.5 mm from the boundary between region A and region C in the short side direction on the surface of the glass substrate.

Furthermore, as shown in Fig. 7, the outer periphery on the surface of the glass substrate is located at the position separated by a distance of 115 mm from the boundary between region C and region B in the short side direction on the surface of the glass substrate.

Furthermore, the pressure within the film forming chamber during formation of each of the amorphous silicon photoelectric conversion layers of sample numbers 1 to 17 was maintained within the range of 500 Pa to 1700 Pa.

Then, the thickness of the amorphous silicon photoelectric conversion layer of each of sample numbers 1 to 17 was measured using a contact-type step/thickness meter. The thickness of the amorphous silicon photoelectric conversion layer can also be measured by observing the cross section of the laminate using a scanning electron microscope (SEM), a transmission electron microscope (TEM), and the like. Furthermore, the thickness of the amorphous silicon photoelectric conversion layer can also be measured by a spectroscopic ellipsometer. In this case, the thickness of the amorphous silicon photoelectric conversion layer on region A on the surface of the glass substrate was measured at optional two positions, while the thickness of the amorphous silicon photoelectric conversion layer on region B on the surface of the glass substrate was measured at optional four positions. Then, the average value of the measured values of the thickness of the amorphous silicon photoelectric conversion layer on region A on the surface of the glass substrate was calculated as an average thickness Da, and the average value of the measured values of the thickness of the amorphous silicon photoelectric conversion layer on region B on the surface of the glass substrate was calculated as an average thickness Db, to calculate a thickness ratio (Db/Da). The results thereof are shown in Table 1.

[Table 1]

| Sample Number | Region A | | | Region B | | | | | Thickness Ratio Db/Da |
|---|---|---|---|---|---|---|---|---|---|
| | Thickness 1 [μm] | Thickness 2 [μm] | Average Thickness Da [μm] | Thickness 1 [μm] | Thickness 2 [μm] | Thickness 3 [μm] | Thickness 4 [μm] | Average Thickness Db [μm] | |
| 1 | 0.332 | 0.328 | 0.330 | 0.277 | 0.286 | 0.271 | 0.286 | 0.280 | 0.85 |
| 2 | 0.327 | 0.335 | 0.331 | 0.272 | 0.286 | 0.273 | 0.284 | 0.279 | 0.84 |
| 3 | 0.320 | 0.328 | 0.324 | 0.292 | 0.281 | 0.298 | 0.295 | 0.292 | 0.90 |
| 4 | 0.293 | 0.306 | 0.300 | 0.253 | 0.280 | 0.261 | 0.258 | 0.263 | 0.88 |
| 5 | 0.332 | 0.334 | 0.333 | 0.274 | 0.271 | 0.284 | 0.267 | 0.274 | 0.82 |
| 6 | 0.331 | 0.331 | 0.331 | 0.251 | 0.225 | 0.275 | 0.262 | 0.253 | 0.76 |
| 7 | 0.336 | 0.327 | 0.332 | 0.280 | 0.278 | 0.268 | 0.279 | 0.276 | 0.83 |
| 8 | 0.303 | 0.313 | 0.308 | 0.263 | 0.273 | 0.260 | 0.275 | 0.268 | 0.87 |
| 9 | 0.316 | 0.315 | 0.316 | 0.286 | 0.291 | 0.287 | 0.288 | 0.288 | 0.91 |
| 10 | 0.325 | 0.333 | 0.329 | 0.280 | 0.274 | 0.281 | 0.270 | 0.276 | 0.84 |
| 11 | 0.284 | 0.278 | 0.281 | 0.242 | 0.264 | 0.240 | 0.274 | 0.255 | 0.91 |
| 12 | 0.291 | 0.296 | 0.294 | 0.259 | 0.268 | 0.258 | 0.261 | 0.262 | 0.89 |
| 13 | 0.314 | 0.316 | 0.315 | 0.270 | 0.271 | 0.288 | 0.274 | 0.276 | 0.88 |
| 14 | 0.327 | 0.331 | 0.329 | 0.287 | 0.262 | 0.321 | 0.279 | 0.287 | 0.87 |
| 15 | 0.332 | 0.339 | 0.336 | 0.296 | 0.289 | 0.299 | 0.293 | 0.294 | 0.88 |
| 16 | 0.291 | 0.304 | 0.298 | 0.293 | 0.274 | 0.286 | 0.276 | 0.282 | 0.85 |
| 17 | 0.324 | 0.314 | 0.319 | 0.288 | 0.276 | 0.303 | 0.297 | 0.291 | 0.91 |

As shown in Table 1, it was confirmed that each of the amorphous silicon photoelectric conversion layers of sample numbers 1 to 17 was configured such that average thickness Db on region B on the surface of the glass substrate was less than average thickness Da on region A thereof.

<Photoelectric Conversion Cell in Examples 1 to 4>

The above-described glass substrate having the amorphous silicon photoelectric conversion layer of sample number 17 formed thereon was again disposed within the film forming chamber of the above-described plasma CVD apparatus, and the gas within the film forming chamber was evacuated until the pressure within the film forming chamber reached 0.1 Pa. Then, $H_2$ gas, $SiH_4$ gas and $B_2H_6$ gas were introduced into the film forming chamber, thereby forming a p type microcrystalline silicon layer on the surface of the n type microcrystalline silicon layer by the plasma CVD method.

After stopping introduction of the gas into the film forming chamber and evacuating the gas within the film forming chamber until the pressure within the film forming chamber reached 0.1 Pa, $H_2$ gas and $SiH_4$ gas were introduced into the film forming chamber, thereby forming a non-doped i type microcrystalline silicon layer on the surface of the p type microcrystalline silicon layer by the plasma CVD method.

After stopping introduction of the gas into the film forming chamber and evacuating the gas within the film forming chamber until the pressure within the film forming chamber reached 0.1 Pa, $H_2$ gas, $SiH_4$ gas and $PH_3$ gas were introduced into the film forming chamber, thereby forming an n type amorphous silicon layer on the surface of the non-doped microcrystalline silicon layer by the plasma CVD method. Then, the flow rate of the $H_2$ gas and the flow rate of the $SiH_4$ gas were changed so as to raise the $H_2/SiH_4$ flow ratio (($H_2$ flow rate)/($SiH_4$ flow rate)), thereby forming an n type microcrystalline silicon layer on the surface of the n type amorphous silicon layer by the plasma CVD method.

Thus, a microcrystalline silicon photoelectric conversion layer was formed by the laminated body including the p type microcrystalline silicon layer, the non-doped i type microcrystalline silicon layer, the n type amorphous silicon layer, and the n type microcrystalline silicon layer produced as described above.

Then, the glass substrate having a microcrystalline silicon photoelectric conversion layer formed thereon was removed from the plasma CVD apparatus and disposed within a magnetron sputtering apparatus. Then, by the magnetron sputtering method, a zinc oxide layer having a thickness of 50 to 80 nm was formed on the surface of the microcrystalline silicon photoelectric conversion layer, and then, a silver layer having a thickness of 100 to 200 nm was formed. In the manner as described above, a super-straight type photoelectric conversion cell in Example 1 was produced.

Furthermore, a super-straight type photoelectric conversion cell in Example 2 was produced in the same manner as in Example 1, except that the photoelectric conversion layer of sample number 6 was used.

Furthermore, the amorphous silicon photoelectric conversion layer of sample number 18 was produced in the same manner as with sample number 17, except that the conditions were changed so as to suppress the change in thickness of the photoelectric conversion layer on region A on the surface of the glass substrate and to increase the thickness of the photoelectric conversion layer on region B.

Furthermore, the amorphous silicon photoelectric conversion layer of sample number 19 was produced in the same manner as with sample number 6, except that the conditions were changed so as to suppress the change in thickness of the photoelectric conversion layer on region A on the surface of the glass substrate and to increase the thickness of the photoelectric conversion layer on region B.

Then, the average thickness on each of regions B and A on the surface of the glass substrate of the amorphous silicon photoelectric conversion layer of each of sample numbers 18 and 19 was measured in the same manner as described above.

Then, super-straight type photoelectric conversion cells in Example 3 (sample number 18 was used) and Example 4 (sample number 19 was used) were produced in the same manner as in Example 1, except that the amorphous silicon photoelectric conversion layers of sample numbers 18 and 19 were used.

Also, for the purpose of reference, super-straight type photoelectric conversion cells in Reference Examples 1 and 2 each having the structure similar to those in Examples 1 to 4 were produced using the conventional plasma CVD apparatus having a leak rate lower than that of the vacuum film forming apparatus used for forming of the photoelectric conversion cells in Examples 1 to 4.

Then, quasi-sunlight was applied at a temperature of 25 °C at AM 1.5 (100mW/cm$^2$) from the glass substrate side to the portions of the amorphous silicon photoelectric conversion layer and the microcrystalline silicon photoelectric conversion layer located in each of regions A and B on the surface of the glass substrate of the photoelectric conversion cell produced as above in each of Examples 1 to 4 and Reference Examples 1 and 2, to measure maximum output power $W_i$ per 1 cm$^2$ of the surface immediately after irradiation of quasi-sunlight and maximum output power $W_e$ per 1 cm$^2$ of the surface after irradiation for 1000 hours.

Then, calculated based on the following equation (XI) was the light degradation rate of the portion of each of the amorphous silicon photoelectric conversion layer and the microcrystalline silicon photoelectric conversion layer located on each of regions A and B on the surface of the glass substrate of the photoelectric conversion cell in each of Examples 1 to 4 and Reference Examples 1 and 2. The results thereof are shown in Tables 2 to 7.

$$\text{Light degradation rate } [\%] = 100 \times (W1_i - W1_e)/(W1_i) \ ... \ (XI)$$

The light degradation rates in regions A and B in each of Tables 2 to 7 were calculated by applying the above-mentioned quasi-sunlight to a small-area cell for 1000 hours that was produced by separating a region having a width of 8 mm and a length of 8 mm by laser scribing from each of regions A and B of the photoelectric conversion cell in each of Examples 1 to 4 and Reference Examples 1 and 2. The light degradation rate of region A shows a value for one small-area cell while the light degradation rate of region B shows an average value of four small-area cells separated from four corners of region B. Furthermore, the light degradation rate of the entire cell in each of Tables 2 to 7 was calculated by applying the above-mentioned quasi-sunlight for 1000 hours to one photoelectric conversion cell having a long side length of 1400 mm $\times$ a short side length of 1000 mm that was produced in the same conditions as those in Examples 1 to 4 and Reference Examples 1 and 2.

Furthermore, after calculation of the above-described light degradation rates, the reflective electrode and the transparent conductive film were wet-etched by a 0.5% hydrochloric acid aqueous solution from the side opposite to the glass substrate of the photoelectric conversion cell in each of Examples 1 to 4 and Reference Examples 1 and 2, thereby exposing the microcrystalline silicon photoelectric conversion layer.

Then, SIMS (secondary ion mass spectrometry) was employed to measure the oxygen concentration [atoms/cm$^3$], the nitrogen concentration [atoms/cm$^3$] and the carbon concentration [atoms/cm$^3$] of the amorphous silicon photoelectric conversion layer that was located on each of regions A and B on the surface of the glass substrate of the photoelectric conversion cell in each of Examples 1 to 4 and Reference Examples 1 and 2. The results thereof are shown in Tables 2 to 7.

The SIMS analysis was conducted by measuring the change in the impurity concentration in the layer thickness direction by argon etching starting from the microcrystalline silicon photoelectric conversion layer. Specifically, in addition to measurement of the oxygen concentration, the nitrogen concentration and the carbon concentration, the concentration of the tin element that is a constituent element of the tin oxide layer on the glass substrate was also measured. Then, the oxygen concentration, the nitrogen concentration and the carbon concentration were measured at the position in the layer thickness direction corresponding to the starting point at which the tin element concentration abruptly starts to increase (by double digits or more in the present Example). With this measuring method, even if concavities and convexities exist on the surface of the amorphous silicon photoelectric conversion layer in the tin oxide layer, the amorphous silicon photoelectric conversion layer has a thickness greater than the height of these concavities and convexities, and therefore, the impurity concentration within the amorphous silicon photoelectric conversion layer can be measured.

Furthermore, it is preferable also to measure the change of the concentration, in the layer thickness direction, of each of boron and phosphorus that are impurity elements of the p type amorphous silicon carbide layer and the n type amorphous and n type microcrystalline silicon layers, respectively, of the amorphous silicon photoelectric conversion layer. As in the present Example, when the measurement is conducted by argon etching starting from the microcrystalline silicon photoelectric conversion layer, the region in which the phosphorus concentration abruptly increases (for example, approximately five times or more) can be identified as a boundary between the microcrystalline silicon photoelectric conversion layer and the amorphous silicon photoelectric conversion layer. Thus, the oxygen concentration, the nitrogen concentration and the carbon concentration may be measured at the position in the layer thickness direction corresponding to the starting point at which the phosphorus concentration abruptly increases. On the other hand, when measurement is conducted by argon etching starting from the glass substrate side, the oxygen concentration, the nitrogen concentration and the carbon concentration can be measured at the position in the layer thickness direction corresponding to the starting point at which the boron concentration abruptly starts to increase (for example, approximately five times or more). Thus, the region in which the boron concentration increases by five times or more can be further identified as a boundary between the amorphous silicon photoelectric conversion layer and the microcrystalline silicon photoelectric conversion layer.

In addition, in Tables 2 to 7, the concentration ratio Pb/Pa shows a value obtained by dividing the oxygen concentration, the nitrogen concentration and the carbon concentration in the amorphous silicon photoelectric conversion layer on region B on the surface of the glass substrate by the oxygen concentration, the nitrogen concentration and the carbon concentration, respectively, in the amorphous silicon photoelectric conversion layer on region A on the surface of the glass substrate.

[Table 2]

| | Example 1 | | | | | | |
|---|---|---|---|---|---|---|---|
| | Oxygen Concentration [atom/cm³] | Nitrogen Concentration [atom/cm³] | Carbon Concentration [atom/cm³] | Average Thickness [μm] | Thickness Ratio Db/Da | Light Degradation Rate [%] | Light Degradation Rate of Entire Cell [%] |
| Region A | $2 \times 10^{20}$ | $2 \times 10^{18}$ | $5 \times 10^{18}$ | 0.319 | 0.91 | 11 | 11 |
| Region B | $7 \times 10^{20}$ | $3 \times 10^{19}$ | $2 \times 10^{19}$ | 0.291 | | 11 | |
| Concentration Ratio Pb/Pa | 3.5 | 15 | 4 | | | | |

[Table 3]

| | Example 2 | | | | | | |
|---|---|---|---|---|---|---|---|
| | Oxygen Concentration [atom/cm³] | Nitrogen Concentration [atom/cm³] | Carbon Concentration [atom/cm³] | Average Thickness [μm] | Thickness Ratio Db/Da | Light Degradation Rate [%] | Light Degradation Rate of Entire Cell [%] |
| Region A | $5 \times 10^{18}$ | $2 \times 10^{17}$ | $3 \times 10^{17}$ | 0.331 | 0.76 | 10 | 11 |
| Region B | $1 \times 10^{20}$ | $1 \times 10^{18}$ | $2 \times 10^{18}$ | 0.253 | | 11 | |
| Concentration Ratio Pb/Pa | 20 | 5 | 6.7 | | | | |

[Table 4]

| | Example 3 | | | | | | |
|---|---|---|---|---|---|---|---|
| | Oxygen Concentration [atom/cm³] | Nitrogen Concentration [atom/cm³] | Carbon Concentration [atom/cm³] | Average Thickness [μm] | Thickness Ratio Db/Da | Light Degradation Rate [%] | Light Degradation Rate of Entire Cell [%] |
| Region A | $2 \times 10^{20}$ | $2 \times 10^{18}$ | $5 \times 10^{18}$ | 0.319 | 0.97 | 11 | 13 |
| Region B | $7 \times 10^{20}$ | $3 \times 10^{19}$ | $2 \times 10^{19}$ | 0.308 | | 14 | |
| Concentration Ratio Pb/Pa | 3.5 | 15 | 4 | | | | |

[Table 5]

| | Example 4 | | | | | | |
|---|---|---|---|---|---|---|---|
| | Oxygen Concentration [atom/cm³] | Nitrogen Concentration [atom/cm³] | Carbon Concentration [atom/cm³] | Average Thickness [μm] | Thickness Ratio Db/Da | Light Degradation Rate [%] | Light Degradation Rate of Entire Cell [%] |
| Region A | $5 \times 10^{18}$ | $2 \times 10^{17}$ | $3 \times 10^{17}$ | 0.328 | 0.96 | 10 | 12 |
| Region B | $1 \times 10^{20}$ | $1 \times 10^{18}$ | $2 \times 10^{18}$ | 0.315 | | 14 | |
| Concentration Ratio Pb/Pa | 20 | 5 | 6.7 | | | | |

[Table 6]

| Reference Example 1 | | | | | | | |
|---|---|---|---|---|---|---|---|
| | Oxygen Concentration [atom/cm³] | Nitrogen Concentration [atom/cm³] | Carbon Concentration [atom/cm³] | Average Thickness [μm] | Thickness Ratio Db/Da | Light Degradation Rate [%] | Light Degradation Rate of Entire Cell [%] |
| Region A | $1 \times 10^{18}$ | $2 \times 10^{17}$ | $2 \times 10^{17}$ | 0.263 | 0.98 | 10 | 11 |
| Region B | $6 \times 10^{18}$ | $7 \times 10^{17}$ | $7 \times 10^{17}$ | 0.259 | | 11 | |
| Concentration Ratio Pb/Pa | 6 | 3.5 | 3.5 | | | | |

[Table 7]

| Reference Example 2 | | | | | | | |
|---|---|---|---|---|---|---|---|
| | Oxygen Concentration [atom/cm³] | Nitrogen Concentration [atom/cm³] | Carbon Concentration [atom/cm³] | Average Thickness [μm] | Thickness Ratio Db/Da | Light Degradation Rate [%] | Light Degradation Rate of Entire Cell [%] |
| Region A | $1 \times 10^{18}$ | $2 \times 10^{17}$ | $2 \times 10^{17}$ | 0.260 | 0.96 | 10 | 11 |
| Region B | $4 \times 10^{18}$ | $4 \times 10^{17}$ | $6 \times 10^{17}$ | 0.250 | | 11 | |
| Concentration Ratio Pb/Pa | 4 | 2 | 3 | | | | |

As shown in Tables 2 to 5, assuming that the average thickness of the amorphous silicon photoelectric conversion layer on region A on the surface of the glass substrate is defined as Da and the average thickness of the amorphous silicon photoelectric conversion layer on region B on the surface of the glass substrate is defined as Db, the photoelectric conversion cells in Examples 1 and 2 satisfying the following equation (I) each could suppress the light degradation rate of the amorphous silicon photoelectric conversion layer on region B corresponding to a peripheral edge region of the glass substrate at a level lower than that in the case of the photoelectric conversion cell in each of Examples 3 and 4 not satisfying the following equation (I). Therefore, the light degradation rate of the entire cell could also be suppressed at a relatively low level.

$$0.76\,\mathrm{Da} \le \mathrm{Db} \le 0.91\,\mathrm{Da} \dots \text{(I)}$$

Furthermore, as shown in Tables 2 to 3 and 6 to 7, the photoelectric conversion cell in each of Examples 1 and 2 produced by the plasma CVD apparatus having a large leak rate was configured such that the amorphous silicon photoelectric conversion layer had average thickness Db on region B on the surface of the glass substrate less than average thickness Da on region A thereof, so as to satisfy the foregoing equation (I).
Accordingly, the light degradation rate of the entire cell could be suppressed at a relatively low level similar to that in the case of the photoelectric conversion cell in each of Reference Examples 1 and 2 produced by the conventional plasma CVD apparatus having a low leak rate.

Furthermore, as shown in Tables 2 and 3, the photoelectric conversion cell in each of Examples 1 and 2 satisfies each of the foregoing equation (I) and the following equations (II) to (VII).

In other words, assuming that the oxygen concentration in the amorphous silicon photoelectric conversion layer on region A on the surface of the glass substrate is defined as Pa(O) and the oxygen concentration of the amorphous silicon photoelectric conversion layer on region B on the surface of the glass substrate is defined as Pb (O), the photoelectric conversion cell in each of Examples 1 and 2 satisfies the following equations (II) and (III).

$$3.5\,\mathrm{Pa(O)} \le \mathrm{Pb(O)} \dots \text{(II)}$$

$$\mathrm{Pb(O)} \ge 1 \times 10^{20}\ [\mathrm{atoms/cm^3}] \dots \text{(III)}$$

Furthermore, assuming that the nitrogen concentration in the amorphous silicon photoelectric conversion layer on region A on the surface of the glass substrate is defined as Pa(N) and the nitrogen concentration in the amorphous silicon photoelectric conversion layer on region B on the surface of the glass substrate is defined as Pb(N), the photoelectric conversion cell in each of Examples 1 and 2 satisfies the following equations (IV) and (V).

$$5\ Pa(N) \le Pb(N) \ ... \ (IV)$$

$$Pb(N) \ge 1 \times 10^{18} \ [atoms/cm^3] \ ... \ (V)$$

Furthermore, assuming that the carbon concentration in the amorphous silicon photoelectric conversion layer on region A on the surface of the glass substrate is defined as Pa(C) and the carbon concentration in the amorphous silicon photoelectric conversion layer on region B on the surface of the glass substrate is defined as Pb(C), the photoelectric conversion cell in each of Examples 1 and 2 satisfies the following equations (VI) and (VII).

$$4\ Pa(C) \le Pb(C) \ ... \ (VI)$$

$$Pb(C) \ge 2 \times 10^{18} \ [atoms/cm^3] \ ... \ (VII)$$

<Photoelectric Conversion Cell in Examples 5 and 6>

A photoelectric conversion cell in Example 5 was produced by making a modification to the configuration of the microcrystalline silicon photoelectric conversion layer of the photoelectric conversion cell in Example 1 as shown in Table 8. Furthermore, a photoelectric conversion cell in Example 6 was produced by making a modification to the configuration of the microcrystalline silicon photoelectric conversion layer of the photoelectric conversion cell in Example 2 as shown in Table 9.

Then, the method similar to those as described above was used to measure the light degradation rate in each of regions A and B in the photoelectric conversion cell in each of Examples 5 and 6, and measure the light degradation rate of the entire cell. The results thereof are shown in Tables 8 and 9.

[Table 8]

| | | Example 5 | | | | Example 1 | | | |
|---|---|---|---|---|---|---|---|---|---|
| | | Microcrystalline Silicon Photoelectric Conversion Layer | | Light Degradation Rate [%] | Light Degradation Rate of Entire Cell [%] | Microcrystalline Silicon Photoelectric Conversion Layer | | Light Degradation Rate [%] | Light Degradation Rate of Entire Cell [%] |
| | | Average Thickness [$\mu$m] | Thickness Ratio Db2/Da2 | | | Average Thickness [$\mu$m] | Thickness Ratio Db2/Da2 | | |
| | Region A | 1.80 | 0.78 | 11 | 10 | 1.76 | 0.97 | 11 | 11 |
| | Region B | 1.41 | | 10 | | 1.70 | | 11 | |

[Table 9]

| | | Example 6 | | | | Example 2 | | | |
|---|---|---|---|---|---|---|---|---|---|
| | | Microcrystalline Silicon Photoelectric Conversion Layer | | Light Degradation Rate [%] | Light Degradation Rate of Entire Cell [%] | Microcrystalline Silicon Photoelectric Conversion Layer | | Light Degradation Rate [%] | Light Degradation Rate of Entire Cell [%] |
| | | Average Thickness [$\mu$m] | Thickness Ratio Db2/Da2 | | | Average Thickness [$\mu$m] | Thickness Ratio Db2/Da2 | | |
| | Region A | 1.79 | 0.77 | 10 | 10 | 1.75 | 0.96 | 10 | 11 |
| | Region B | 1.37 | | 10 | | 1.68 | | 11 | |

As shown in Tables 8 and 9, assuming that the average thickness of the microcrystalline silicon photoelectric conversion layer on region A on the surface of the glass substrate is defined as Da2 and the average thickness of the microcrystalline silicon photoelectric conversion layer on region B on the surface of the glass substrate is defined as Db2, the photoelectric conversion cell in each of Examples 5 and 6 satisfying the following equation (VIII) could suppress the light degradation rate of the microcrystalline silicon photoelectric conversion layer on region B corresponding to a peripheral edge region of the glass substrate at a level lower than those in the case of the photoelectric conversion cells in Examples 1 and 2 not satisfying the following equation (VIII). Therefore, the light degradation rate of the entire cell could also be suppressed at a relatively low level.

$$0.76\, Da2 \leq Db2 \leq 0.91\, Da2\, ...\, (VIII)$$

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

INDUSTRIAL APPLICABILITY

The present invention can be applied to a photoelectric conversion device.

REFERENCE SIGNS LIST

1 substrate, 1a peripheral edge surface, 1b cut surface, 2 transparent conductive film, 3 first p type semiconductor layer, 4 first i type semiconductor layer, 5 first n type semiconductor layer, 6 second p type semiconductor layer, 7 second i type semiconductor layer, 8 second n type semiconductor layer, 9 transparent conductive film, 10 reflective electrode, 11 first pin type photoelectric conversion layer, 12 second pin type photoelectric conversion layer, 13 cell structure body, 13a first cell structure body, 13b second cell structure body, 13c third cell structure body, 21, 22, 23 solid line, 31 cathode, 32 anode, 33 gas introduction pipe, 34 arrow, 35 impedance matching circuit, 36 high-frequency power supply, 37 gas discharge pipe, 38 arrow, 39 gate valve, 40 pump, 41 film forming chamber, 51 third p type semiconductor layer, 52 third i type semiconductor layer, 53 third n type semiconductor layer, 54 third pin type photoelectric conversion layer, 111 glass substrate, 112 transparent electrode, 113 photovoltaic film, 113a p layer, 113b i layer, 113c n layer, 114 backside electrode.

**Claims**

1. A photoelectric conversion device comprising:

   a substrate (1); and
   a pin type photoelectric conversion layer (11, 12) disposed on a surface of said substrate (1),
   said pin type photoelectric conversion layer (11, 12) including a first pin type photoelectric conversion layer (11) formed by stacking a p type semiconductor layer (3), an i type semiconductor layer (4) serving as an amorphous semiconductor layer and an n type semiconductor layer (5),
   said first pin type photoelectric conversion layer (11) including a first portion located on a part of the surface of said substrate (1) and a second portion located on another part of the surface of said substrate (1),
   said first portion being higher in concentration of at least one impurity element selected from oxygen, nitrogen and carbon than said second portion, and
   said first portion being less in thickness than said second portion.

2. The photoelectric conversion device according to claim 1, wherein
   said first portion is located on a peripheral edge region on the surface of said substrate (1) and
   said second portion is located on a center region on the surface of said substrate (1) corresponding to a region inside with respect to said peripheral edge region.

3. The photoelectric conversion device according to claim 2, wherein
   assuming that a center point on the surface of said substrate (1) is defined as an A point,
   an optional one point on an outer periphery on the surface of said substrate (1) is defined as a B point, and
   points dividing a line segment AB connecting said A point and said B point internally in a ratio 0.115:0.655:0.23 are defined as a C point and a D point sequentially from the A point side,
a region between a course of said B point and a course of said D point obtained when said B point is moved around once along the outer periphery on the surface of said substrate (1) while said A point is fixed is defined as said peripheral edge region, and
a region inside a course of said C point is defined as said center region, and
assuming that an average thickness of said second portion is defined as Da and an average thickness of said first portion is defined as Db,
the following equation (I) is satisfied;

$$0.76\,Da \leq Db \leq 0.91\,Da \ldots (I).$$

4.   The photoelectric conversion device according to claim 2 or 3, wherein assuming that a center point on the surface of said substrate (1) is defined as an A point,
an optional one point on an outer periphery on the surface of said substrate (1) is defined as a B point, and
points dividing a line segment AB connecting said A point and said B point internally in a ratio 0.115:0.655:0.23 are defined as a C point and a D point sequentially from the A point side,
a region between a course of said B point and a course of said D point obtained when said B point is moved around once along the outer periphery on the surface of said substrate (1) while said A point is fixed is defined as said peripheral edge region, and
a region inside a course of said C point is defined as said center region, and assuming that an oxygen concentration in said second portion is defined as Pa(O) and an oxygen concentration in said first portion is defined as Pb(O), the following equation (II) is satisfied;

$$3.5\,Pa(O) \leq Pb(O) \ldots (II).$$

5.   The photoelectric conversion device according to any one of claims 2 to 4, wherein
assuming that a center point on the surface of said substrate (1) is defined as an A point,
an optional one point on an outer periphery on the surface of said substrate (1) is defined as a B point, and
points dividing a line segment AB connecting said A point and said B point internally in a ratio 0.115:0.655:0.23 are defined as a C point and a D point sequentially from the A point side,
a region between a course of said B point and a course of said D point obtained when said B point is moved around once along the outer periphery on the surface of said substrate (1) while said A point is fixed is defined as said peripheral edge region, and
a region inside a course of said C point is defined as said center region, and
assuming that an oxygen concentration in said first portion is defined as Pb(O), the following equation (III) is satisfied;

$$Pb(O) \geq 1 \times 10^{20}\ [atoms/cm^3] \ldots (III).$$

6.   The photoelectric conversion device according to any one of claims 2 to 5, wherein
assuming that a center point on the surface of said substrate (1) is defined as an A point,
an optional one point on an outer periphery on the surface of said substrate (1) is defined as a B point, and
points dividing a line segment AB connecting said A point and said B point internally in a ratio 0.115:0.655:0.23 are defined as a C point and a D point sequentially from the A point side,
a region between a course of said B point and a course of said D point obtained when said B point is moved around once along the outer periphery on the surface of said substrate (1) while said A point is fixed is defined as said peripheral edge region, and
a region inside a course of said C point is defined as said center region, and assuming that a nitrogen concentration in said second portion is defined as Pa(N) and a nitrogen concentration in said first portion is defined as Pb(N), the following equation (IV) is satisfied;

$$5\,Pa(N) \leq Pb(N) \ldots (IV).$$

7.   The photoelectric conversion device according to any one of claims 2 to 6, wherein

assuming that a center point on the surface of said substrate (1) is defined as an A point,

an optional one point on an outer periphery on the surface of said substrate (1) is defined as a B point, and

points dividing a line segment AB connecting said A point and said B point internally in a ratio 0.115:0.655:0.23 are defined as a C point and a D point sequentially from the A point side,

a region between a course of said B point and a course of said D point obtained when said B point is moved around once along the outer periphery on the surface of said substrate (1) while said A point is fixed is defined as said peripheral edge region, and

a region inside a course of said C point is defined as said center region, and

assuming that a nitrogen concentration in said first portion is defined as Pb(N), the following equation (V) is satisfied;

$$\mathrm{Pb(N)} \geq 1 \times 10^{18}\ [\mathrm{atoms/cm^3}] \ ...\ \mathrm{(V)}.$$

8. The photoelectric conversion device according to any one of claims 2 to 7, wherein

assuming that a center point on the surface of said substrate (1) is defined as an A point,

an optional one point on an outer periphery on the surface of said substrate (1) is defined as a B point, and

points dividing a line segment AB connecting said A point and said B point internally in a ratio 0.115:0.655:0.23 are defined as a C point and a D point sequentially from the A point side,

a region between a course of said B point and a course of said D point obtained when said B point is moved around once along the outer periphery on the surface of said substrate (1) while said A point is fixed is defined as said peripheral edge region, and

a region inside a course of said C point is defined as said center region, and assuming that a carbon concentration in said second portion is defined as Pa(C) and a carbon concentration in said first portion is defined as Pb(C),

the following equation (VI) is satisfied;

$$4\ \mathrm{Pa(C)} \leq \mathrm{Pb(C)} \ ...\ \mathrm{(VI)}.$$

9. The photoelectric conversion device according to any one of claims 2 to 8, wherein

assuming that a center point on the surface of said substrate (1) is defined as an A point,

an optional one point on an outer periphery on the surface of said substrate (1) is defined as a B point, and

points dividing a line segment AB connecting said A point and said B point internally in a ratio 0.115:0.655:0.23 are defined as a C point and a D point sequentially from the A point side,

a region between a course of said B point and a course of said D point obtained when said B point is moved around once along the outer periphery on the surface of said substrate (1) while said A point is fixed is defined as said peripheral edge region, and

a region inside a course of said C point is defined as said center region, and

assuming that a carbon concentration in said first portion is defined as Pb(C), the following equation (VII) is satisfied;

$$\mathrm{Pb(C)} \geq 2 \times 10^{18}\ [\mathrm{atoms/cm^3}] \ ...\ \mathrm{(VII)}.$$

10. The photoelectric conversion device according to any one of claims 1 to 9, wherein

said pin type photoelectric conversion layer (11, 12) includes said first pin type photoelectric conversion layer (11) and a second pin type photoelectric conversion layer (12) in this order from the substrate (1) side,

said second pin type photoelectric conversion layer (12) includes a p type semiconductor layer (6), an i type semiconductor layer (7) and an n type semiconductor layer (8), and

said second pin type photoelectric conversion layer (12) is less in thickness in said first portion than in said second portion.

11. The photoelectric conversion device according to claim 10, wherein

said first portion is located on a peripheral edge region on the surface of said substrate (1),

said second portion is located on a center region on the surface of said substrate (1) corresponding to a region inside with respect to said peripheral edge region, and

assuming that a center point on the surface of said substrate (1) is defined as an A point,

an optional one point on an outer periphery on the surface of said substrate (1) is defined as a B point, and

points dividing a line segment AB connecting said A point and said B point internally in a ratio 0.115:0.655:0.23 are defined as a C point and a D point sequentially from the A point side,

a region between a course of said B point and a course of said D point obtained when said B point is moved around once along the outer periphery on the surface of said substrate (1) while said A point is fixed is defined as said peripheral edge region, and

a region inside a course of said C point is defined as said center region, and

assuming that an average thickness of said second pin type photoelectric conversion layer (12) in said second portion is defined as Da2 and an average thickness of said second pin type photoelectric conversion layer (12) in said first portion is defined as Db2,

the following equation (VIII) is satisfied;

$$0.76 \, Da2 \leq Db2 \leq 0.91 \, Da2 \, ... \, (VIII).$$

12. The photoelectric conversion device according to claim 10 or 11, wherein said first portion is located on a peripheral edge region on the surface of said substrate (1),

said second portion is located on a center region on the surface of said substrate (1) corresponding to a region inside with respect to said peripheral edge region, and

assuming that a center point on the surface of said substrate (1) is defined as an A point,

an optional one point on an outer periphery on the surface of said substrate (1) is defined as a B point, and

points dividing a line segment AB connecting said A point and said B point internally in a ratio 0.115:0.655:0.23 are defined as a C point and a D point sequentially from the A point side,

a region between a course of said B point and a course of said D point obtained when said B point is moved around once along the outer periphery on the surface of said substrate (1) while said A point is fixed is defined as said peripheral edge region, and

a region inside a course of said C point is defined as said center region, and

assuming that an average thickness of said second portion is defined as Da, an average thickness of said first portion is defined as Db, an average thickness of said second pin type photoelectric conversion layer (12) in said second portion is defined as Da2, and an average thickness of said second pin type photoelectric conversion layer (12) in said first portion is defined as Db2,

the following equation (IX) is satisfied;

$$Db2/Da2 \leq Db/Da \, ... \, (IX).$$

13. The photoelectric conversion device according to claim 1, wherein

an end face of said substrate (1) having said first portion provided thereon includes a portion to which a semiconductor component adheres and a portion to which said semiconductor component does not adhere, and

an end face of said substrate (1) having said second portion provided thereon has said semiconductor component not adhering thereto.

FIG.1

FIG.2

FIG.3

FIG.4

FIG.5

FIG.6

(a)

(b)

(c)

FIG.7

FIG.8

FIG.9

FIG.10

FIG.11

OUTPUT
POWER

EARLY STAGE

LIGHT IRRADIATION TIME

AFTER STABILIZATION
(APPROXIMATELY
1000 HOURS)

## INTERNATIONAL SEARCH REPORT

| International application No. |
| --- |
| PCT/JP2011/053357 |

A. CLASSIFICATION OF SUBJECT MATTER
*H01L31/04* (2006.01) i

According to International Patent Classification (IPC) or to both national classification and IPC

B. FIELDS SEARCHED

Minimum documentation searched (classification system followed by classification symbols)
H01L31/04

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 6-45252 A (Director General, Agency of Industrial Science and Technology), 18 February 1994 (18.02.1994), entire text; all drawings & US 5246744 A & EP 488112 A1 & DE 69103251 C2 | 1-13 |
| A | JP 2006-245061 A (Sanyo Electric Co., Ltd.), 14 September 2006 (14.09.2006), entire text; all drawings & US 2006/0207648 A1 & EP 1696493 A1 & CN 1828946 A | 1-13 |

☒ Further documents are listed in the continuation of Box C. ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>24 May, 2011 (24.05.11) | Date of mailing of the international search report<br>31 May, 2011 (31.05.11) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2011/053357 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2008-4813 A  (Sharp Corp.),<br>10 January 2008 (10.01.2008),<br>entire text; all drawings<br>& US 2009/0183771 A1     & EP 2037721 A1<br>& WO 2007/148569 A1      & CN 101480111 A | 1-13 |
| A | JP 5-48133 A  (Nippondenso Co., Ltd.),<br>26 February 1993 (26.02.1993),<br>entire text; all drawings<br>(Family: none) | 1-13 |
| A | JP 2003-51604 A  (Sanyo Electric Co., Ltd.),<br>21 February 2003 (21.02.2003),<br>entire text; all drawings<br>(Family: none) | 1-13 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000277773 A